# EUROPÄISCHE PATENTANMELDUNG

(11) **EP 3 901 717 A2**
(43) Veröffentlichungstag der Anmeldung: **27.10.2021**
(21) Anmeldenummer: 21169573.9
(22) Anmeldetag: 21.04.2021
(51) Int. Cl.: G05B 19/401, G01B 5/008

(54) **VERFAHREN UND VORRICHTUNG ZUR BESTIMMUNG EINER MESSSTRATEGIE ZUR VERMESSUNG EINES MESSOBJEKTS SOWIE PROGRAMM**

(30) Priorität: 21.04.2020 EP 20170618
(71) Anmelder: Carl Zeiss Industrielle Messtechnik GmbH, 73447 Oberkochen (DE)
(72) Erfinder: Häring, Rolf, 89537 Giengen (DE); Haas, Günter, 73432 Aalen (DE); Bux, Herbert, 73466 Lauchheim (DE)
(74) Vertreter: Ramrath, Lukas

(57) **Zusammenfassung**

Die Erfindung betrifft ein Verfahren und eine Vorrichtung zur Bestimmung einer Messstrategie zur Vermessung eines Messobjekts (1), wobei mindestens ein Prüfelement des Messobjekts (1) bestimmt wird, wobei für das Prüfelement automatisiert geprüft wird, ob eine anwendbare Messregel in einer Messregel-Menge von vorab festgelegten Messregeln existiert, wobei einer neuen Messstrategie eine anwendbare Messregel hinzugefügt oder die prüfelementspezifische Messregel einer existierenden Messstrategie in Abhängigkeit einer anwendbaren Messregel geändert wird,
dadurch gekennzeichnet, dass
die Messregeln der Messregel-Menge bestimmt werden, indem für ein Prüfelement eine Messregel sowie mindestens ein Prüfkriterium zu deren Anwendbarkeit durch einen Nutzer oder (teil-)automatisiert festgelegt werden, wobei die Messregel mindestens einen Parameter zur Vermessung des Prüfelements festlegt, sowie ein Programm.

## Beschreibung

Die Erfindung betrifft ein Verfahren und eine Vorrichtung zur Bestimmung einer Messstrategie zur Vermessung eines Messobjekts sowie ein Programm.

Zur Vermessung eines Messobjekts mittels einer Koordinatenmesseinrichtung wird in der Regel eine Messstrategie festgelegt. Durch diese wird beispielsweise festgelegt, welcher Sensor zur Vermessung verwendet wird, welche Messbahnen abgefahren werden, wieviel Messpunkte entlang dieser Messbahnen erzeugt werden, wie eine Auswertung der erzeugten Messpunkte erfolgt, welche Prüfelemente des Messobjekts vermessen werden sowie weitere für die Vermessung und die Auswertung notwendige oder gewünschte Parameter.

In der Regel erfolgte diese Bestimmung der Messstrategie durch einen Nutzer, der die entsprechenden Parameter manuell vorgibt. Ebenfalls bekannt ist die Nutzung des "Zeiss Messstrategien Cookbook, Herausgeber: Zeiss Acadamy Metrology, Verlag: Carl Zeiss AG, 2017". In diesem Cookbook sind Vorschläge zur Lösung von Messaufgaben enthalten, die ein Nutzer zur Bestimmung und Festlegung der Messstrategie nutzen kann, wobei diese dann durch eine entsprechende Eingabe festgelegt wird.

Nachteilig ist, dass die derart bestimmten Messstrategien abhängig von der Nutzererfahrung sind und somit Nutzereinflüsse auf ein Messergebnis vorhanden sind, was in der Regel unerwünscht ist. Ferner ergibt sich der Nachteil, dass in der Regel ein hoher Zeitaufwand benötigt wird, um die Messstrategie manuell festzulegen.

Aus dem Stand der Technik bekannt ist die WO02/23292 A2 beschreibt ein Verfahren zum Generieren eines Messprogrammes für ein Koordinatenmessgerät, insbesondere Multisensor-Koordinatenmessgerät, wobei in einer das Koordinatenmessgerät steuernden Datenverarbeitungseinrichtung ein Soll Datensatz wie CAD-Datensatz eines zu messenden Objektes eingelesen wird.

Die DE 102015 114 715 A1 offenbart ein Verfahren zur Erstellung eines Messprogramms zur Bestimmung von geometrischen Merkmalen und/oder Strukturen an einem Werkstück.

Die Webseite https://wiki.elias-gmbh.de/doku.php?id=de:infra-convert:info, Stand: 13.03.2020 offenbart die Software infra Convert, mit der automatisiert Prüfpläne erstellt werden können.

Die Webseite https://www.afm-tec.info/software-loesungen/afm-gerberconvert/, Stand: 13.03.2020 offenbart, dass Prüfpläne zur Messung von Elektronikplatinen vollautomatisch erzeugt werden können.

Es stellt sich das technische Problem, ein Verfahren und eine Vorrichtung zur Bestimmung einer Messstrategie zur Vermessung eines Messobjekts sowie ein Programm zu schaffen, welche eine zeitlich schnelle Bestimmung von reproduzierbaren und vergleichbaren Messstrategien ermöglichen, die insbesondere auch nachträglich zur Änderung von bereits erzeugten Messstrategien dienen können und die Nutzereinflüsse auf die durch die Messstrategie bedingte Messqualität reduzieren.

Die Lösung des technischen Problems ergibt durch die Gegenstände mit den Merkmalen der unabhängigen Ansprüche. Weitere vorteilhafte Ausgestaltungen der Erfindung ergeben sich aus den Unteransprüchen.

Vorgeschlagen wird ein Verfahren zur Bestimmung einer Messstrategie zur Vermessung eines Messobjekts. Ein solches Messobjekt kann auch als Prüfkörper bezeichnet werden.

Die Vermessung des Messobjekts kann insbesondere mit einer Koordinatenmesseinrichtung erfolgen. Eine solche Koordinatenmesseinrichtung kann beispielsweise in Ständer- oder Portalbauweise ausgebildet sein. Selbstverständlich können jedoch auch davon verschiedene Koordinatenmesseinrichtungen verwendet werden. Hierbei ist vorstellbar, dass das Messobjekt mittels der Messstrategie taktil, also durch mechanische Antastung mit einem sogenannten taktilen Sensor, und/oder optisch, also durch optische Antastung mittels eines optischen Sensors, vermessen wird. Entsprechende Sensoren und Verfahren zur Vermessung sind dem Fachmann hierbei bekannt. Die Messstrategie legt hierbei die Messaufgabe sowie die zur Vermessung einzustellenden Parameter fest. Insbesondere legt die Messstrategie auch fest, welche Prüfelemente des Messobjekts in welcher Art und Weise vermessen werden. Auch kann durch die Messstrategie festgelegt werden in welcher Art und Weise die Messergebnisse ausgewertet werden.

Gemäß dem vorgeschlagenen Verfahren wird mindestens ein Prüfelement des Messobjekts bestimmt, insbesondere in einem Bestimmungsschritt. Dieses Prüfelement kann insbesondere modellbasiert bestimmt werden, beispielsweise auf Basis eines CAD-Modells des Messobjekts. Vorzugsweise kann hierbei ein CAD-Modell mit sogenannten PMI (Production Manufactoring Information) genutzt werden, welches neben den geometrischen Informationen des Messobjekts auch Toleranzinformationen sowie Informationen zu vorhandenen Prüfelementen kodiert/umfasst. Selbstverständlich ist es auch möglich, dass Prüfelemente auf Basis eines CAD-Modells (teil-)automatisiert oder durch einen Nutzer identifiziert und festgelegt werden. Verfahren zur (teil-)automatisierten Identifikation und Festlegung von Prüfelementen sind dem Fachmann hierbei bekannt.

Alternativ ist es auch möglich, das Messobjekt zu vermessen, beispielsweise mittels der Koordinatenmesseinrichtung, für die die erfindungsgemäß zu bestimmende Messstrategie bestimmt wird, oder mittels einer davon verschiedenen, weiteren Koordinatenmesseinrichtung. Durch eine solche Vermessung kann beispielsweise eine dreidimensionale Repräsentation des Messobjekts erzeugt werden. Hiernach kann (teil-) automatisiert oder durch einen Nutzer auf Basis dieser dreidimensionalen Repräsentation das mindestens eine Prüfelement des Messobjekts bestimmt werden. Hierbei kann die Messstrategie zur Vermessung des Messobjekts zur Erzeugung der Repräsentation für die Bestimmung von Prüfelementen von der wie vorgeschlagen zu bestimmenden Messstrategie verschieden sein.

Als Prüfelement kann insbesondere ein geometrisches Element des Messobjekts bestimmt werden, wobei exemplarische geometrische Elemente des Messobjekts nachfolgend noch näher erläutert werden.

Weiter wird, insbesondere in einem Prüfschritt, geprüft, ob für das Prüfelement eine anwendbare Messregel in einer Messregel-Menge von vorab festgelegten Messregeln existiert. Diese Prüfung erfolgt automatisiert.

Eine Messregel legt hierbei Parameter der Vermessung des Prüfelements fest, z.B. eine Geschwindigkeit der Relativbewegung zwischen einem Sensor der Koordinatenmesseinrichtung und dem Messobjekt bei der Vermessung gemäß der Messstrategie, eine Anzahl und/oder eine Lage der zu erzeugenden Messpunkte, eine Anzahl und/oder Lage der durch den Sensor abzufahrenden Messbahnen, einen Winkelbereich der Messung sowie gegebenenfalls weitere notwendige oder gewünschte Parameter der Vermessung. Mit anderen Worten kann eine Messregel Arbeitsanweisungen zur Durchführung der Vermessung des Prüfelements kodieren, z.B. in Form von Befehlen, die zur Durchführung und Datenerzeugung einzustellenden Prüfparameter, z.B. Beleuchtungsparameter oder Antastkräfte, sowie die zur Durchführung der Prüfung zu verwendenden Prüfkomponenten, z.B. Sensoren, festlegen. Auch kann eine Messregel Parameter enthalten, die zur Laufzeit der Vermessung eingestellt oder verändert werden können, z.B. um zeitlich nachfolgende Prüf(teil)prozesse anzupassen. Mit anderen Worten kann die Messregel Vorschriften enthalten/kodieren, welche einen gewünschten Messablauf zur Vermessung des Prüfelements mittelbar oder unmittelbar beschreiben. Die Messregel kann somit Teil der Messstrategie sein, wenn diese in die Messstrategie integriert wird. Die vorab festgelegten Messregeln der Messregel-Menge können beispielsweise in Form einer Datenbank von Messregeln bereitgestellt werden, wobei diese z.B. in einer Speichereinrichtung abrufbar abgespeichert sind.

Ferner können den derart gespeicherten Messregeln jeweils mindestens ein Prüfkriterium zu deren Anwendbarkeit zugeordnet sein, wobei das Prüfkriterium sowie gegebenenfalls Parameter zur Prüfung des Prüfkriteriums in den Messregeln zugeordneter Weise ebenfalls abgespeichert sein können, beispielsweise in der Speichereinrichtung. Diese Speichereinrichtung kann z.B. eine Cloud-basierte Speichereinrichtung sein. Selbstverständlich kann diese jedoch auch eine lokale Speichereinrichtung sein. Eine Speichereinrichtung kann beispielsweise ein RAM- oder ROM-Speicher sein.

Weiter wird einer neuen Messstrategie eine anwendbare Messregel hinzugefügt oder die prüfelementspezifische Messregel einer existierenden Messstrategie in Abhängigkeit der anwendbaren Messregel geändert, wenn eine solche anwendbare Messregel für das Prüfelement in der Messregel-Menge existiert. Beispielsweise kann eine existierende Messregel einer existierenden Messstrategie durch die anwendbare Messregel ersetzt werden. Das Hinzufügen oder Ändern kann hierbei vollautomatisiert oder teilautomatisiert erfolgen, wobei beim vollautomatisierten Verfahren keine Zustimmung eines Nutzers, z.B. durch eine Nutzereingabe, und im teilautomatisierten Verfahren eine Nutzerbestätigung angefordert wird. Beispielsweise kann im teilautomatisierten Verfahren einem Nutzer die anzuwendende prüfelementspezifische Messregel vorgeschlagen werden, beispielsweise durch die Darstellung entsprechender Informationen auf einer Anzeigeeinrichtung. Existiert für ein betrachtetes Prüfelement (nachfolgend auch als ausgewähltes Prüfelement bezeichnet) keine anwendbare Messregel bzw. wird keine anwendbare Messregel identifiziert, so kann eine Default-Messregel als anwendbare Messregel für das Prüfelement bestimmt werden. Alternativ kann eine anwendbare Messregel basierend auf mindestens einer ähnlichen Messregel der existierenden Messregel-Menge bestimmt werden. Weiter alternativ kann eine anwendbare Messregel in Abhängigkeit mindestens einer Eigenschaft eines Messszenarios bestimmt werden. Weiter alternativ kann eine anwendbare Messregel durch Auswertung von existierenden Messregeln bestimmt werden. Diese Bestimmung einer anwendbaren Messregel kann automatisiert oder teilautomatisiert erfolgen.

Existiert keine anwendbare Messregel in der Messregel-Menge, so kann z.B. zuerst geprüft werden, ob eine ähnliche Messregel in der Messregel-Menge existiert. Kann keine ähnliche Messregel identifiziert werden, so kann als anwendbare Messregel eine Default-Messregel bestimmt werden. Alternativ kann geprüft werden, ob eine anwendbare Messregel in Abhängigkeit mindestens einer Eigenschaft eines Messszenarios oder durch Auswertung existierender Messregeln bestimmt werden kann. Ist dies nicht der Fall, so kann als anwendbare Messregel eine Default-Messregel bestimmt werden.

So kann/können durch eine Default-Messregel ein oder mehrere der nachfolgend angeführten Parameter wie folgt festgelegt werden:
- eine Relativgeschwindigkeit zwischen Sensor und Messobjekt auf einen Wert kleiner als oder gleich 5 mm/s,
- eine Anzahl der pro Messbahn zu erzeugenden Messpunkte auf einen Wert größer als oder gleich 3600 oder auf einen Wert derart, dass bei einer vorgegebenen Grenzwellenlänge (von z.B. 0.8 mm) eines Filters zur Auswertung die Wellenlängen kleiner als diese Grenzwellenlänge in der Auswertung der gefilterten Messpunkte eindeutig bestimmt werden können,
- eine Antastkraft auf einen Wert kleiner als oder gleich 100 mN,
- eine Länge einer kreisförmigen Messbahn auf einen Wert größer als die Umfangslänge des Kreises,
- eine Anzahl der abzufahrenden Messbahnen auf einen Wert von Eins,
- die Lage der zu erzeugenden Messpunkte derart, dass diese gleichverteilt entlang der Messbahn angeordnet sind,
- eine Lage der abzufahrenden Messbahn derart, dass diese 5% oder mehr einer Dimension (Länge, Breite) eines, insbesondere flächig ausgebildeten, Prüfelements vom Rand des Prüfelements entfernt angeordnet ist,
- die Grenzwellenlänge eines Filters zur Filterung auf einen Wert von 0.8 mm,
- der Typ eines Sensors als taktiler Sensor,
- der Durchmesser einer Tastkugel eines taktilen Sensors auf einen Wert kleiner als oder gleich 2mm,
- die Anzahl der in einem vorbestimmten Zeitintervall zu erfassenden Messpunkte derart, dass mit einer vorgegebenen Relativgeschwindigkeit kleiner als oder gleich 5 mm/s entlang der Messbahn die Anzahl der pro Messbahn zu erzeugenden Messpunkte (s.o.) erreicht wird.

Eine anwendbare Messregel basierend auf mindestens einer ähnlichen, existierenden Messregel der Messregel-Menge kann bestimmt werden, indem ein Ähnlichkeitsmaß zwischen dem ausgewählten Prüfelement, für das keine anwendbare Messregel in der Messregel-Menge identifiziert werden kann, und den Prüfelementen ausgewertet wird, denen existierende Messregeln der Messregel-Menge zugeordnet sind, wobei die anwendbare Messregel als die Messregel bestimmt wird, die einem Prüfelement zugeordnet ist, für das das Ähnlichkeitsmaß größer als ein vorbestimmter Schwellwert ist oder für das das Ähnlichkeitsmaß am größten ist.

Ein Ähnlichkeitsmaß kann als Größe bestimmt werden, die negativ mit einer Abweichung zwischen einer vorbestimmten Soll-Toleranz für das ausgewählte Prüfelement und einer Toleranz für ein Prüfelement, dem eine existierende Messregel zugeordnet ist, korreliert (je größer die Abweichung, desto kleiner das Ähnlichkeitsmaß). Eine beispielhafte negativ korrelierende Größe ist der Kehrwert. Die Toleranz für ein Prüfelement, dem eine existierende Messregel zugeordnet ist, kann hierbei in Abhängigkeit der durch diese existierende Messregel festgelegten Parameter bestimmt werden, z.B. durch eine Simulation, modellbasiert oder auf Basis einer vorbekannten Zuordnung zwischen Parametern und Toleranz.

Auch kann ein Ähnlichkeitsmaß als Größe bestimmt werden, die negativ mit einer Abweichung zwischen mindestens einer Eigenschaft oder einer von mindestens einer Eigenschaft abhängigen Größe des ausgewählten Prüfelements und einer korrespondierenden Eigenschaft/Größe eines Prüfelements, dem eine existierende Messregel zugeordnet ist, korreliert. Eine solche Eigenschaft/Größe kann beispielsweise eine Eigenschaft sein, die bei Prüfung des Kriteriums zur Anwendbarkeit der existierenden Messregel geprüft wird.

Selbstverständlich kann das Ähnlichkeitsmaß auch als Größe bestimmt werden, die negativ mit einer fusionierten Abweichung zwischen Eigenschaften/Größen korreliert, wobei die fusionierte Abweichung in Abhängigkeit der Abweichung zwischen mehreren, einzelnen Eigenschaften bestimmt wird, beispielsweise als Summe oder positiv korrelierend. Es ist möglich, dass einzelne Eigenschaften bei der Bestimmung der fusionierten Abweichung mit verschiedenen Gewichtungsfaktoren gewichtet werden.

Auch kann das Ähnlichkeitsmaß als Größe bestimmt werden, die negativ mit einer fusionierten Abweichung korreliert, wobei die fusionierte Abweichung in Abhängigkeit der Abweichung zwischen einer oder mehreren Eigenschaften und der erläuterten Toleranzabweichung bestimmt wird, beispielsweise als Summe oder positiv korrelierend.

Eine anwendbare Messregel basierend auf mindestens einer Eigenschaft eines Messszenarios kann bestimmt werden, indem eine Eigenschaft des Messszenarios bestimmt wird und dann eine eigenschaftsspezifische Messregel als die anwendbare Messregel bestimmt wird. Eine Eigenschaft des Messszenarios kann beispielsweise sein: eine Größe, die den zur Vermessung vorgesehenen Sensortyp repräsentiert, eine Größe, die die Rauigkeit des Messobjekts bzw. des Prüfelements repräsentiert und/oder eine Größe, die das zur Herstellung des Messobjekts bzw. des Prüfelements verwendete Herstellungsverfahren repräsentiert.

Das Messszenario kann ein prüfelementspezifisches oder messobjektspezifisches Messszenario sein. Die Eigenschaft(en) des Messszenarios kann/können vorbestimmt bzw. vorgegeben sein.

Ein Sensortyp kann beispielsweise optisch oder taktil sein. Ein Herstellungsverfahren kann insbesondere ein urformendes, umformendes, trennendes, fügendes, beschichtendes oder stoffeigenschaftänderndes Herstellungsverfahren sein. Insbesondere kann ein Herstellungsverfahren ein additives oder zerspanendes Herstellungsverfahren sein.

Die Bestimmung einer eigenschaftsspezifischen Messregel kann erfolgen, indem, insbesondere automatisiert oder teilautomatisiert, eine vorbestimmte Zuordnung zwischen verschiedenen Messszenarien mit verschiedenen Eigenschaften und diesen verschiedenen Messszenarien zugeordneten Messregeln ausgewertet wird, wobei für ein ausgewähltes Prüfelement als anwendbare Messregel die Messregel bestimmt wird, die dem Messszenario zugeordnet ist, dessen Eigenschaften weniger als ein vorbestimmtes Maß von den Eigenschaften des Messszenarios für das ausgewählte Prüfelement abweichen oder für das diese Abweichung minimal ist. Eine solche Zuordnung kann insbesondere in einer Speichereinrichtung gespeichert sein und durch eine geeignete Auswerteeinrichtung ausgewertet werden.

Eine anwendbare Messregel für ein ausgewähltes Prüfelement basierend auf einer Auswertung von existierenden Messregeln kann bestimmt werden, indem durch eine Auswertung, insbesondere Interpretation, von existierenden Messregeln ein Zusammenhang zwischen Prüfelementen und prüfelementspezifisch anwendbaren Messregeln bestimmt wird, wobei die anwendbare Messregel für das ausgewählte Prüfelement dann basierend auf dem derart bestimmten Zusammenhang bestimmt wird. Die existierenden Messregeln können insbesondere die bereits existierenden Messregeln der Messregel-Menge sein.

Insbesondere können statistische Methoden der Datenauswertung auf eine Datenmenge angewendet werden, um Zusammenhänge zu identifizieren, insbesondere Zusammenhänge zwischen Prüfelementen und prüfelementspezifisch anwendbaren Messregeln. Die Datenmenge kann Informationen über verschiedene Prüfelemente, insbesondere auch über mindestens eine Eigenschaft der verschiedenen Prüfelemente, und über die für die verschiedenen Prüfelemente bereits festgelegten Messregeln umfassen. Insbesondere können statistische Kennwerte ermittelt und zur Bestimmung einer anwendbaren Messregel genutzt werden. Die statistischen Methoden können insbesondere ein Verfahren zur Verdichtung der Daten umfassen bzw. anwenden. Alternativ oder kumulativ können Data-Mining Methoden angewendet werden, um einen Zusammenhang zwischen einem Prüfelement bzw. dessen Eigenschaften und einer für das Prüfelement anwendbaren Messregel zu identifizieren, wobei der derart identifizierte Zusammenhang dann zur Bestimmung einer anwendbaren Messregel für ein ausgewähltes Prüfelement genutzt wird.

Auch kann durch die Auswertung von existierenden Messregeln ein durch maschinelles Lernen erzeugtes Modell bestimmt werden, wobei die anwendbare Messregel für das Prüfelement dann basierend auf dem derart bestimmten Modell bestimmt wird. Der Begriff maschinelles Lernen umfasst oder bezeichnet hierbei Verfahren zur Bestimmung von Messregeln basierend auf Trainingsdaten. So ist es möglich, dass ein Modell durch Verfahren zum überwachten Lernen bestimmt wird, welches einen Zusammenhang zwischen einem Prüfelement bzw. dessen Eigenschaften und einer für das Prüfelement anwendbaren Messregel abbildet. Natürlich ist es auch möglich, dass das Modell einen Zusammenhang zwischen einem Prüfelement bzw. dessen Eigenschaften und einer für das Prüfelement anwendbaren Messregel sowie eines Kriteriums zu deren Anwendbarkeit abbildet.

Trainingsdaten können Eingangs- und Ausgangsgrößen umfassen. Z.B. können Eingangsgrößen die Prüfelemente bzw. Eigenschaften der Prüfelemente sein, für die bereits Messregeln und gegebenenfalls Kriterien zur Anwendbarkeit festgelegt wurden. Ausgangsgrößen können die prüfelementspezifischen Messregeln und gegebenenfalls Kriterien zur Anwendbarkeit sein. Es ist selbstverständlich aber auch vorstellbar, dass zur Bestimmung des Modells Verfahren des unüberwachten Lernens angewendet werden. Geeignete mathematische Algorithmen für das maschinelle Lernen umfassen: Decision Tree-basierte Verfahren, Ensemble Methods (z.B. Boosting, Random Forrest) -basierte Verfahren, Regression-basierte Verfahren, Bayes'sche Methoden (z.B. Bayesian Belief Networks)-basierte Verfahren, Kernel Methoden (z.B. Support Vector Machines)-basierte Verfahren, Instance- (z.B. k-Nearest Neighbour)-basierte Verfahren, Association Rule Learning-basierte Verfahren, Boltzmann Maschine-basierte Verfahren, Artificial Neural Networks (z.B. Perceptron) -basierte Verfahren, Deep Learning (z.B. Convolutional Neural Networks, Stacked Autoencoders) -basierte Verfahren, Dimensionality Reduction-basierte Verfahren, Regularization Methods-basierte Verfahren. Es ist auch vorstellbar, dass Regeln mittels eines neuronalen Netzes bestimmt werden. Beispielsweise kann das neuronale Netz als Autoencoder oder als faltendes neuronales Netz (Convolutional Neural Network, CNN) oder als RNN (Recurrent Neural Network) oder als LSTM-Netz (long short-term memory network) oder als neuronales Transformer-Netz oder als eine Kombination aus mindestens zwei der erwähnten Netze ausgebildet sein. Auch ist es möglich, Verfahren der künstlichen Intelligenz zur Bestimmung der Regeln anzuwenden. Solche sind dem Fachmann bekannt.

Die derart bestimmte anwendbare Messregel kann der neuen Messstrategie hinzugefügt werden bzw. oder es kann die prüfelementspezifische Messregel der existierenden Messstrategie in Abhängigkeit der derart bestimmten anwendbaren Messregel geändert werden. Hierdurch ergibt sich in vorteilhafter Weise eine zeitlich schnelle Bestimmung einer Messstrategie, die eine hohe Reproduzierbarkeit gewährleistet und wobei auch Nutzereinflüsse auf die Messqualität mit dieser Messstrategie verringert sind.

Wird für das Prüfelement keine anwendbare Messregel in der Messregel-Menge identifiziert, so kann der neuen Messstrategie eine vorbestimmte Default-Messregel hinzugefügt oder die prüfelementspezifische Messregel einer existierenden Messstrategie auf die Default-Messregel geändert werden. Diese Default-Messregel kann insbesondere eine prüfmerkmaltypspezifische oder prüfmerkmalgruppenspezifische Default-Messregel sein und somit für alle Prüfelemente des gleichen Typs oder der gleichen Gruppe gleich sein.

Eine automatisierte Bestimmung einer Messregel kann eine Bestimmung ohne Nutzeraktion, insbesondere ohne Nutzereingabe, bezeichnen. Bei einer teilautomatisierten Bestimmung kann z.B. eine Datenverarbeitungseinrichtung genau eine oder mehrere Messregel(n) für ein Prüfelement identifizieren und einem Nutzer vorschlagen, z.B. über eine Informationsausgabeeinrichtung wie z.B. eine Anzeigeeinrichtung, durch die entsprechende Informationen dargestellt werden können. Der Nutzer kann dann, z.B. mittels der Eingabeeinrichtung, diese Messregel oder eine dieser Messregeln auswählen, wobei die ausgewählte Messregel die anwendbare Messregel bildet. Erfindungsgemäß werden die Messregeln der Messregel-Menge bestimmt, indem für ein Prüfelement eine Messregel sowie mindestens ein Prüfkriterium zu deren Anwendbarkeit durch einen Nutzer oder (teil-)automatisiert festgelegt werden, wobei die Messregel - wie vorhergehend bereits erläutert - mindestens einen Parameter zur Vermessung des Prüfelements festlegt, insbesondere die erläuterte Relativgeschwindigkeit, die Anzahl der Messpunkte und gegebenenfalls weitere Parameter.

Festlegbare Parameter der Messregel können z.B. sein: ein Sensorparameter eines Sensors der Koordinatenmesseinrichtung, eine Anzahl der in einem vorbestimmten Zeitintervall durch den Sensor zu erfassenden Messpunkte, ein Parameter der räumlichen Verteilung der zu erfassenden Messpunkte, eine Geschwindigkeit einer Relativbewegung zwischen Messobjekt und Sensor, eine Anzahl von Messbahnen, eine Länge einer Messbahn, ein Filterparameter zur Filterung der Messwerte, ein Auswerteparameter zur Auswertung der Messwerte oder ein Parameter zur Temperaturkompensation ist oder repräsentiert. Ein Sensorparameter kann ein Antastparameter eines Sensors der Koordinatenmesseinrichtung sein. Ein Antastparameter kann insbesondere eine Antastkraft und/oder eine Antastorientierung sein. Ein Sensorparameter kann auch ein Fokuswert eines optischen Sensors der Koordinatenmesseinrichtung sein oder repräsentieren. Ein Parameter der Messstrategie kann auch eine Anzahl der in einem vorbestimmten Zeitintervall durch den Sensor zu erfassenden Messpunkte sein oder repräsentieren. Diese Anzahl pro Zeitintervall kann beispielsweise auch als Erfassungsrate oder Scanning-Rate bezeichnet werden. Weiter kann der mindestens eine Parameter ein Parameter der räumlichen Verteilung der zu erfassenden Messpunkte sein oder repräsentieren. Weiter kann der mindestens eine Parameter eine (maximale) Geschwindigkeit einer Relativbewegung zwischen Messobjekt und Sensor der Koordinatenmesseinrichtung sein oder repräsentieren. Diese Geschwindigkeit kann auch als Scanning-Geschwindigkeit bezeichnet werden, wenn eine sogenannte scannende Erfassung von Messpunkten, also eine Erfassung von Messpunkten während der Durchführung einer Relativbewegung erfolgt. Weiter kann der mindestens eine Parameter eine Anzahl von voneinander verschiedenen Messbahnen zur Vermessung des Messobjekts sein oder repräsentieren. Weiter kann der mindestens eine Parameter eine Länge einer Messbahn oder die Gesamtlänge aller Messbahnen sein oder repräsentieren. Weiter kann der mindestens eine Parameter ein Filterparameter zur Filterung der Messwerte sein oder repräsentieren. Weiter kann der Parameter ein Auswerteparameter zur Auswertung der Messwerte sein oder repräsentieren. Weiter kann der Parameter ein Parameter eines Verfahrens zur Temperaturkompensation sein oder repräsentieren.

Bevorzugt ist oder repräsentiert der Parameter die Geschwindigkeit, insbesondere die maximale oder durchschnittliche Geschwindigkeit, der Relativbewegung zwischen Messobjekt und Sensor und/oder die Anzahl der in einem vorbestimmten Zeitintervall zu erfassenden Messpunkte während der Vermessung durch die Messstrategie

Ein Prüfkriterium kann hierbei vorgegeben werden, indem z.B. die Art der Prüfung und mindestens eine Soll-Größe zur Erfüllung des Prüfkriteriums vorgegeben wird. Eine Art der Prüfung kann beispielsweise ein Vergleich sein, also insbesondere eine Prüfung, ob eine Ist-Größe kleiner als, kleiner oder gleich, gleich, größer oder gleich oder größer als die Soll-Größe ist. Die Soll-Größe kann beispielsweise ein numerischer Wert oder ein numerischer Wertebereich sein. Dies ist aber nicht zwingend. Auch kann die Soll-Größe andere Merkmale repräsentieren. So kann eine Soll-Größe beispielsweise ein bestimmter Sensortyp, z.B. der Typ "optischer Sensor" sein, wobei z.B. geprüft wird, ob der zur Vermessung durch die Messstrategie festgelegter Sensor ein optischer Sensor ist oder nicht.

Insbesondere kann ein Prüfkriterium derart festgelegt werden, dass bei einer Prüfung des Prüfkriteriums mindestens eine Eigenschaft des Prüfelements oder eine von dieser Eigenschaft abhängige Größe ausgewertet wird, insbesondere mit einer Soll-Größe verglichen wird. Zur Bestimmung, ob das Prüfkriterium erfüllt ist oder nicht, kann also mindestens eine prüfelementspezifische Eigenschaft ausgewertet werden. Beispielhafte prüfelementspezifische Eigenschaften werden nachfolgend noch erläutert. Eine Eigenschaft des Prüfmerkmals kann auch als Prüfmerkmal bezeichnet werden bzw.

Die Nutzereingabe zur Festlegung kann hierbei über mindestens eine Eingabeeinrichtung erfolgen. Diese kann beispielsweise geeignete Eingabemittel zur Nutzereingabe umfassen. Auch kann die Eingabeeinrichtung eine Anzeigeeinrichtung zur Darstellung einer grafischen Repräsentation der Messregel sowie von Informationen zum anwendbaren Prüfkriterium umfassen oder mit einer solchen verbunden sein. Beispielsweise kann diese Anzeigeeinrichtung als Bildschirm ausgebildet sein. Durch die Anzeigeeinrichtung kann beispielsweise eine grafische Repräsentation von Informationen zum Prüfelement, zum Prüfkriterium (z.B. zur Art der Prüfung und der Soll-Größe) der zu prüfenden Eigenschaft des Prüfelements und zum festzulegenden Parameter der Messregel angezeigt werden. Werden, wie nachfolgend noch näher erläutert, für ein Prüfelement mindestens zwei Prüfkriterien zur Bestimmung der Messregel festgelegt, so können diese ebenfalls in geeigneter Weise durch die Anzeigeeinrichtung dargestellt werden. Beispielsweise können Informationen zu einem nachfolgenden Prüfkriterium in Relation zu den Informationen eines vorangegangenen Prüfkriteriums in eingerückter Art und Weise dargestellt werden. Auch können voneinander Informationen zu verschiedenen Soll-Größen, die einer Eigenschaft des Prüfelements zugeordnet sind, in Relation zu dieser Eigenschaft in eingerückter Art und Weise dargestellt werden.

Alternativ oder kumulativ zum Hinzufügen der wie vorhergehend erläutert bestimmten anwendbaren Messregel für ein ausgewähltes Prüfelement, für das keine anwendbare Messregel existiert bzw. keine anwendbare Messregel identifiziert wird, zur Messstrategie bzw. zum Ändern der existierenden Messstrategie ist es auch möglich, dass die derart bestimmte anwendbare Messregel der Messregel-Menge hinzugefügt wird. In diesem Fall wird zusätzlich zur anwendbaren Messregel noch mindestens ein Prüfkriterium zu deren Anwendbarkeit bestimmt. Auch die Bestimmung des Prüfkriteriums kann automatisiert oder teilautomatisiert erfolgen. Somit kann also eine automatisierte oder teilautomatisierte Festlegung einer Messregel und mindestens eines Prüfkriteriums zu deren Anwendbarkeit erfolgen, indem - wie vorhergehend erläutert - eine anwendbare Messregel bestimmt wird und ebenfalls ein Kriterium zur Anwendbarkeit dieser Messregel. In diesem Fall erfolgt in vorteilhafter Weise eine automatische Bildung der Messregel-Menge, welche nachfolgend eine zeitlich schnelle Bestimmung von reproduzierbaren und vergleichbaren Messstrategien ermöglicht und auch Nutzereinflüsse auf die Messqualität verringert.

Für den automatischen Aufbau der Messregel-Menge ist es aber nicht zwingend notwendig, dass ein ausgewähltes Prüfelement als Prüfelement eines Messobjekts bestimmt wird. So ist es auch vorstellbar, ein ausgewähltes Prüfelement zu erzeugen, indem eine oder mehrere Eigenschaften von Prüfelementen, denen bereits existierende Messregeln zugeordnet sind, in vorbestimmter Weise verändert werden. Auf diese Weise kann/können ein oder mehrere messobjektunabhängige(s) Prüfelement(e), die auch als simulierte Prüfelemente bezeichnet werden können, erzeugt werden, wobei dann für diese jeweils eine anwendbare Messregel sowie mindestens ein Kriterium zu deren Anwendbarkeit bestimmt und der Messregel-Menge hinzugefügt werden. Dies kann auch als messobjektunabhängiger Aufbau der Messregel-Menge bezeichnet werden. Ein solcher messobjektunabhängiger Aufbau kann jedoch bereits eine existierende Messregel-Menge oder zumindest existierenden Messregeln, die Prüfelementen zugeordnet sind, erfordern. Ein Prüfelement kann einer Messregel zugeordnet sein, wenn das mindestens eine Prüfkriterium zu deren Anwendbarkeit für das Prüfelement erfüllt ist. Für ein ausgewähltes Prüfelement, für das keine Messregel in der Messregel-Menge identifiziert werden kann, kann ein Prüfkriterium, insbesondere automatisiert oder teilautomatisiert, in gleicher Weise wie eine anwendbare Messregel bestimmt werden.

Wird die anwendbare Messregel für das ausgewählte Prüfelement als Default-Messregel bestimmt, so kann das Prüfkriterium als Default-Kriterium bestimmt werden. Ein solches Kriterium kann beispielsweise erfüllt sein, wenn eine Abweichung von einer, ausgewählten oder allen Eigenschaft(en) des ausgewählten Prüfelements kleiner als ein vorbestimmtes Maß, insbesondere Null, ist.

Wird eine anwendbare Messregel basierend auf mindestens einer ähnlichen, existierenden Messregel der Messregel-Menge bestimmt, so kann als Prüfkriterium das dieser ähnlichen Messregel zugeordnete Prüfkriterium bestimmt werden.

Wird eine anwendbare Messregel basierend auf mindestens einer Eigenschaft eines Messszenarios bestimmt, so kann, insbesondere automatisiert oder teilautomatisiert, eine vorbestimmte Zuordnung zwischen verschiedenen Messszenarien mit verschiedenen Eigenschaften und diesen verschiedenen Messszenarien zugeordneten Prüfkriterien ausgewertet werden, wobei für ein ausgewähltes Prüfelement als Prüfkriterium dann das Prüfkriterium bestimmt wird, die dem Messszenario zugeordnet ist, dessen Eigenschaften weniger als ein vorbestimmtes Maß von den Eigenschaften des Messszenarios für das ausgewählte Prüfelement abweichen oder für das diese Abweichung minimal ist. Eine solche Zuordnung kann insbesondere in einer Speichereinrichtung gespeichert sein und durch eine geeignete Auswerteeinrichtung ausgewertet werden. Es ist auch möglich, dass - wie vorhergehend erläutert - die Messregel basierend auf mindestens einer Eigenschaft eines Messszenarios bestimmt wird und dieser Messregel mindestens ein Prüfkriterium zu deren Anwendbarkeit zugeordnet ist, welches dann als anwendbares Prüfkriterium bestimmt wird.

Wird die anwendbare Messregel für das ausgewählte Prüfelement basierend auf einer Auswertung von existierenden Messregeln bestimmt, so kann ein Zusammenhang zwischen Prüfelementen und prüfelementspezifisch anwendbaren Messregeln sowie Kriterien zu deren Anwendbarkeit bestimmt werden, wobei die anwendbare Messregel und mindestens ein Kriterium zu deren Anwendbarkeit für das Prüfelement dann basierend auf dem derart bestimmten Zusammenhang bestimmt wird.

Die ausgewertete Datenmenge kann hierfür Informationen über verschiedene Prüfelemente, insbesondere auch über mindestens eine Eigenschaft der verschiedenen Prüfelemente, und über die für die verschiedenen Prüfelemente bereits festgelegten Messregeln sowie über die Kriterien zu deren Anwendbarkeit umfassen. In diesem Fall kann ein Zusammenhang zwischen einem Prüfelement bzw. dessen Eigenschaften und einer für das Prüfelement anwendbaren Messregel sowie mindestens einem Kriterium zu deren Anwendbarkeit identifiziert werden, wobei der derart identifizierte Zusammenhang dann zur Festlegung der Messregel und des Kriteriums zu deren Anwendbarkeit genutzt wird. Wie vorhergehend erläutert, kann der Zusammenhang in Form eines durch maschinellen Lernens erzeugten Modells bestimmt werden.

Bei einer teilautomatisierten Festlegung der Messregel sowie des Prüfkriteriums kann z.B. eine Datenverarbeitungseinrichtung einem Nutzer genau ein oder mehrere Prüfkriterien sowie Messregel(n) für ein Prüfelement identifizieren und vorschlagen. Dies kann beispielsweise durch die Darstellung von entsprechenden Informationen auf der erläuterten Anzeigeeinrichtung erfolgen. Der Nutzer kann dann, z.B. mittels der Eingabeeinrichtung, diese Messregel oder eine dieser Messregeln und ein oder mehrere Prüfkriterien zu deren Anwendbarkeit auswählen. Hierbei kann die Datenverarbeitungseinrichtung die entsprechende Identifizierung durch Auswertung von vorbekannten Messregeln/Prüfkriterien zur Vermessung von vorbekannten Prüfelementen durchführen. Vorbekannte Prüfelemente und ihnen zugeordnete Messregeln/Prüfkriterien können beispielsweise ebenfalls in einer Datenbank gespeichert sein.

Z.B. kann die Identifizierung erfolgen, indem die Datenverarbeitungseinrichtung ein Ähnlichkeitsmaß zwischen einem Prüfelement des Messobjekts und einem vorbekannten Prüfelement, dem eine Messregel sowie mindestens ein Prüfkriterium zu deren Anwendbarkeit zugeordnet sind, bestimmt, und dem Prüfelement des Messobjekts die Messregel und das mindestens eine Prüfkriterium dann zuordnet, wenn das Ähnlichkeitsmaß höher als ein vorbestimmtes Maß ist. Selbstverständlich sind jedoch auch andere Ausführungsformen zur (teil-)automatisierten Identifizierung von Messregeln sowie mindestens einem Prüfkriterium zu deren Anwendbarkeit vorstellbar.

Bei der vollautomatisierten Festlegung der Messregel sowie des mindestens einen Prüfkriteriums zu deren Anwendbarkeit kann eine Datenverarbeitungseinrichtung eine geeignete Messregel ebenfalls - wie vorhergehend erläutert - identifizieren und dann der neuen Messstrategie hinzufügen oder die bereits existierende prüfelementspezifische Messregel einer existierenden Messstrategie ändern. Alternativ oder kumulativ kann eine geeignete, anwendbare Messregel und mindestens ein Kriterium zur Anwendbarkeit - wie vorhergehend erläutert - identifiziert und der Messregel-Menge hinzugefügt werden.

Eine Datenverarbeitungseinrichtung kann hierbei auch als Recheneinrichtung bezeichnet werden und als Mikrocontroller oder integrierte Schaltung ausgebildet sein oder eine(n) solche(n) umfassen.

Ein Verfahren zur (teil-)automatisierten Bestimmung und Festlegung kann beispielsweise ein selbstlernendes Verfahren sein. Dies kann beispielsweise derart ausgestaltet sein, dass eine mittels des Verfahrens festgelegte Messregel der vorhergehend erläuterten Menge von vorbekannten Messregeln, die einem Prüfelement zugeordnet sind, hinzugefügt wird und dann für eine nachfolgende (teil-)automatisierte Bestimmung und Festlegung zur Verfügung steht.

Das gemeinsame Festlegen einer Messregel sowie des mindestens einen Prüfkriteriums zu deren Anwendbarkeit ermöglicht hierbei in technisch vorteilhafter Weise eine zeitlich schnelle Bestimmung/Erzeugung einer Messstrategie, welche zu reproduzierbaren und vergleichbaren Messergebnissen bei gleichen Messobjekten, gleichartigen Messobjekten (z.B. Messobjekten einer Serie) oder verschiedenen Messobjekten führt, da für die Bestimmung der jeweils messobjektspezifischen Messstrategie auf die gleiche Messregel-Menge zurückgegriffen wird, die zusätzlich zur Festlegung der Parameter zur Vermessung auch ein Prüfkriterium zur Anwendbarkeit der entsprechenden Messregel enthält. Somit kann sichergestellt werden, dass für gleiche Prüfelemente oder Prüfelemente mit gleichen Eigenschaften die gleichen Messregeln verwendet werden.

Weiter ist es möglich, dass verschiedene Messregeln für verschiedene Eigenschaften des Prüfelements festgelegt werden können. Beispielsweise können für verschiedene Durchmesser eines Zylinders, verschiedene Geschwindigkeiten der Relativbewegung zwischen Sensor und Messobjekt und/oder verschiedene Anzahlen von Messpunkten und/oder verschiedene zu vermessende Winkelbereiche festgelegt werden.

Insbesondere ist es für einen Nutzer nicht mehr notwendig, für ein identifiziertes Prüfelement des Messobjekts Messregelparameter sowie Kriterien zur Anwendung dieser Messregel einzeln und unabhängig voneinander festzulegen. Ferner kann durch die Art und Weise der gemeinsamen Festlegung eine gewünschte und reproduzierbare Anpassung der Vermessung an Eigenschaften des Prüfelements erfolgen, wobei hierdurch die erläuterten reproduzierbaren und vergleichbaren Messergebnisse bei der Vermessung eines Messobjekts erzeugt werden können.

Ebenfalls kann somit eine Standardisierung von Messverfahren erfolgen. Weiter wird ein sehr schnelles Erstellen von Messstrategien ermöglicht, wobei diese auch anwenderspezifisch sein können. Durch die Regelerstellung können auch existierende Erfahrungen in die Messstrategiebestimmung einfließen. Vorhandene Messstrategien können in einfacher Weise modifiziert, insbesondere optimiert werden.

Im Fall, dass eine anwendbare Messregel eine bereits existierende prüfelementspezifische Messregel ändert, beispielsweise ersetzt, ergibt sich ebenfalls die erläuterte Bereitstellung einer reproduzierbaren und vergleichbaren Messstrategie für ein Messobjekt, bei der Nutzereinflüsse auf die Messqualität verringert werden.

In einer weiteren Ausführungsform wird ein Prüfkriterium derart festgelegt, dass bei einer Prüfung des Prüfkriteriums mindestens eine geometrische Eigenschaft des Prüfelements oder eine davon abhängige Größe ausgewertet wird. Diese geometrische Eigenschaft kann, wie vorhergehend erläutert, für das Prüfelement des Messobjekts bestimmt werden, beispielsweise modellbasiert oder durch eine Vermessung. Beispielhafte geometrische Eigenschaften werden nachfolgend noch näher erläutert. Hierdurch ergibt sich in vorteilhafter Weise eine besonders gute Anpassung der Parameter zur Vermessung (die durch die Messregel festgelegt werden) an zu erwartende geometrische Eigenschaften des Prüfelements beim realen Messobjekt, welches mittels der wie vorgeschlagen zu bestimmenden Messtrategie vermessen werden soll. Diese Anpassung ermöglicht in vorteilhafter Weise das Erreichen einer hohen Messgüte.

Alternativ oder kumulativ wird das Prüfkriterium derart festgelegt, dass eine Umgebungsbedingung ausgewertet wird. Eine Umgebungsbedingung kann beispielsweise eine Temperatur, eine Feuchtigkeit, ein Beleuchtungsparameter wie z.B. eine Lichtintensität oder ein weiterer Umgebungsparameter sein. Beispielsweise kann das Prüfkriterium derart festgelegt werden, dass eine bestimmte Messregel dann angewendet wird, wenn eine Umgebungstemperatur einer vorbestimmten Temperatur entspricht oder in einem vorbestimmten Temperaturbereich liegt. Hierdurch ergibt sich in vorteilhafter Weise eine besonders gute Anpassung der Parameter zur Vermessung an Umgebungsbedingungen und somit ebenfalls eine Verbesserung der Messgüte der Vermessung mittels der wie vorgeschlagen zu bestimmenden Messstrategie.

Weiter alternativ oder kumulativ wird das Prüfkriterium derart festgelegt, dass eine vorbestimmte Toleranz des Prüfelements ausgewertet wird. Toleranzinformationen können modellbasiert bestimmt werden, z.B. aus einem CAD-Modell mit PMI. So können beispielsweise für größere Toleranzen andere Parameter zur Vermessung des Prüfelements verwendet werden als bei im Vergleich niedrigeren Toleranz, wobei aber die gleiche Messgüte gewährleistet werden kann. Hierdurch kann in vorteilhafter Weise erreicht werden, dass eine zur Vermessung mittels der wie vorgeschlagen zu bestimmenden Messstrategie benötigte Messdauer reduziert wird.

Weiter alternativ oder kumulativ wird das Prüfkriterium derart festgelegt, dass ein Messgerätetyp und/oder ein Sensortyp und/oder ein Bauzustand des Messobjekts und/oder eine Messgüte einer vorangegangenen Vermessung ausgewertet wird, wobei die vorangegangene Messung z.B. gemäß einer Messstrategie durchgeführt wurde, die wie in dieser Offenbarung vorgeschlagen bestimmt wurde. Dies wird nachfolgend noch näher erläutert. Hierdurch ergibt sich in vorteilhafter Weise eine besonders gute Anpassung der Messregel und somit auch der zu erreichenden Messgüte an den Messgerätetyp und/oder den Sensortyp und/oder den Bauzustand des Messobjekts und/oder eine Messgüte einer existierenden Messstrategie, die dann geändert werden kann. Vorteile der messgüteabhängigen Anpassung werden nachfolgend noch näher erläutert.

Im Falle der Berücksichtigung des Bauzustands ergibt sich in vorteilhafter Weise, dass eine Messdauer reduziert werden kann, da z.B. Messobjekte in einem Vor-Fertigstellung-Zustand nicht mit der gleichen (hohen) Messgüte vermessen werden müssen wie Messobjekte in einem fertiggestellten Zustand.

In einer weiteren Ausführungsform wird zur Prüfung, insbesondere zur vorhergehend erläuterten automatisierten Prüfung, einer Anwendbarkeit der Messregel mindestens eine geometrische Eigenschaft des Prüfelements oder eine davon abhängige Größe bestimmt. Dieses kann - wie ebenfalls vorhergehend bereits erläutert - modellbasiert oder auf Grundlage einer Vermessung des Messobjekts erfolgen. Alternativ oder kumulativ wird eine Umgebungsbedingung bestimmt. Beispielsweise kann eine Temperatur durch mindestens einen Temperatursensor bestimmt werden, wobei dieser Temperatursensor datentechnisch mit der Datenverarbeitungseinrichtung zur automatisierten Prüfung der Anwendbarkeit verbunden sein kann, beispielsweise über ein Bussystem.

Weiter alternativ oder kumulativ wird eine vorbestimmte Toleranz bestimmt, beispielsweise modellbasiert. Weiter alternativ oder kumulativ wird ein Messgerätetyp und/oder ein Sensortyp und/oder ein Bauzustand des Messobjekts bestimmt und/oder eine Messgüte einer existierenden Messstrategie bestimmt. Zur Bestimmung des Messgerätetyps und/oder des Sensortyps kann die Datenverarbeitungseinrichtung zur Durchführung der automatisierten Anwendbarkeitsprüfung mit einer entsprechenden Steuer- und/oder Auswerteeinrichtung des Messgeräts oder des Sensors verbunden sein und entsprechende Typinformationen abfragen. Selbstverständlich ist es auch möglich, dass ein Nutzer den Messgerätetyp und/oder den Sensortyp durch eine Nutzereingabe eingibt. Der Bauzustand des Messobjekts kann beispielsweise in Abhängigkeit weiterer Prozessparameter bestimmt werden bzw. durch einen Nutzer eingegeben werden.

Die Messgüte kann mit dem Fachmann bekannten Verfahren zur Bestimmung der Messgüte bestimmt werden. Beispielhafte Verfahren sind nachfolgend noch erläutert. Zur Bestimmung der Messgüte kann das Messobjekt vermessen werden, insbesondere mit einer wie vorgeschlagen bestimmten Messstrategie, wobei dann Messregeln dieser Messstrategie messgüteabhängig geändert werden können.

Insgesamt können alle zur Prüfung, ob eine anwendbare Messregel existiert, notwendigen Parameter bestimmt oder erfasst werden. Auch kann ein Nutzer zur Eingabe der entsprechenden Parameter aufgefordert werden, beispielsweise durch eine entsprechende Darstellung der Aufforderung auf der vorhergehend erläuterten Anzeigeeinrichtung.

Hierdurch ergibt sich in vorteilhafter Weise die vorhergehend bereits erläuterte gute Anpassung der Messregel und somit der Messstrategie an geometrische Eigenschaften, Umgebungsbedingungen, Toleranzen, einen Messgerätetyp, einen Sensortyp und/oder einen Bauzustand, wodurch eine hohe Messgüte und/oder eine schnelle Messdauer durch die wie vorgeschlagen zu bestimmende Messstrategie erreicht werden können. Ebenfalls ergibt sich, dass auch die Reproduzierbarkeit der Messergebnisse gesteigert wird sowie Nutzereinflüsse bei der Bestimmung der Messstrategie weiter reduziert werden, da für verschiedene Umgebungsbedingungen, Toleranzen, Messgerätetypen, Sensortypen und/oder Bauzustände verschiedene Messregeln definiert werden können, die dann aber im erfindungsgemäßen Verfahren nutzerunabhängig oder mit reduzierter Nutzerabhängigkeit festgelegt werden.

In einer weiteren Ausführungsform sind verschiedenen Prüfelementen jeweils prüfelementspezifische Eigenschaften zugeordnet, wobei für ein Prüfelement ein Prüfkriterium derart festgelegt wird, dass bei einer Prüfung des Prüfkriteriums ausschließlich mindestens eine prüfelementspezifische Eigenschaft des Prüfelements oder die davon abhängige Größe ausgewertet wird. Mit anderen Worten wird sichergestellt, dass für ein Prüfelement nur zulässige Eigenschaften zur Bestimmung einer anwendbaren Messregel ausgewertet werden. Verschiedene Prüfelemente können hierbei verschiedene prüfelementspezifische Eigenschaften aufweisen.

Werden beispielsweise einem Nutzer bei der Festlegung einer Messregel sowie des zugehörigen Prüfkriterium zu deren Anwendbarkeit verschiedene Kriterien vorgeschlagen oder zur Auswahl angeboten, so kann der Vorschlag bzw. das Angebot auf solche Prüfkriterien beschränkt werden, die zur Auswertung nur prüfelementspezifische Eigenschaften des Prüfelements benötigen. Insbesondere kann einem Nutzer kein Prüfkriterium vorgeschlagen oder angeboten werden, welches zur Auswertung eine Eigenschaft benötigt, die das Prüfelement nicht aufweist. Hierdurch erhöht sich in vorteilhafter Weise eine Qualität der zu bestimmenden Messstrategie, wobei Nutzereinflüsse weiter reduziert werden.

Eine Zuordnung von prüfelementspezifischen Eigenschaften zu Prüfelementen kann hierbei vorbekannt sein und beispielsweise in Form einer Datenbank abrufbar in einer entsprechenden Speichereinrichtung gespeichert sein. Beispielsweise kann somit sichergestellt werden, dass ein die Breitengröße auswertendes Prüfkriterium nicht auf ein zylinderförmiges Prüfelement angewendet wird, da schon bereits bei der Festlegung der Messregel für ein Prüfelement sichergestellt werden kann, dass nur prüfelementspezifische Eigenschaften ausgewertet werden. Hiermit wird auch sichergestellt, dass bei der automatisierten Prüfung auf die Anwendbarkeit von Messregeln tatsächlich nur vorhandene, prüfelementspezifische Eigenschaften ausgewertet werden, wodurch sich die Zeitdauer zur Bestimmung der Messstrategie in vorteilhafter Weise verringert, da keine Maßnahmen zur Behandlung einer Auswertung von Eigenschaften vorgesehen werden müssen, die das Prüfelement nicht aufweist.

In einer weiteren Ausführungsform werden für Prüfung der Anwendbarkeit einer Messregel für ein Prüfelement mindestens zwei Prüfkriterien festgelegt, die in mindestens zwei aufeinanderfolgenden Prüfschritten zu prüfen sind. Beispielsweise können in aufeinanderfolgenden Prüfschritten verschiedene prüfelementspezifische Eigenschaften des Prüfelements geprüft werden. Auch kann in aufeinanderfolgenden Prüfschritten die gleiche prüfelementspezifische Eigenschaft in Bezug auf verschiedene Soll-Größen geprüft werden. Hierdurch ergibt sich in vorteilhafter Weise eine besonders gute Anpassung einer Messregel an ein Prüfelement und somit eine hohe Messgüte bei der Vermessung mit der wie vorgeschlagen zu bestimmenden Messstrategie.

Kollidieren die sich in verschiedenen Prüfschritten ergebenden Messregeln, z.B. weil durch sie unterschiedliche Werte desselben Parameters festgelegt sind, so können geeignete Maßnahmen zur Kollisionsvermeidung durchgeführt werden. Z.B. kann in einem solchen Fall die Messregel der neuen Messstrategie hinzugefügt oder zur Änderung einer existierenden Messstrategie genutzt werden, die sich im zuerst oder zuletzt durchgeführten Prüfschritt ergeben hat.

So kann z.B. als Messregel für ein Prüfmerkmal festgelegt werden, dass eine Erfassung von Messpunkten entlang von 5 gleichmäßig verteilten Bahnen erfolgen soll, wobei das Prüfkriterium zur Anwendung dieser Messregel derart festgelegt wird, dass die Messregel angewendet wird, wenn die geometrische Form des Prüfmerkmals eine Zylinderform ist. Dieses Prüfkriterium kann z.B. in einem ersten Prüfschritt ausgewertet werden.

Als weitere Messregel für ein Prüfmerkmal kann festgelegt werden, dass eine Erfassung von Messpunkten entlang von 3 gleichmäßig verteilten Bahnen erfolgen soll, wobei das Prüfkriterium zur Anwendung dieser Messregel derart festgelegt wird, dass die Messregel angewendet wird, wenn die Eigenschaft Durchmesser des Prüfmerkmals ausgewertet werden soll. Dieses Prüfkriterium kann z.B. in einem weiteren Prüfschritt, der nach dem ersten Prüfschritt durchgeführt wird, ausgewertet werden.

Wird dann z.B. als Prüfmerkmal ein Zylinder ausgewählt, so weist dieser das Prüfmerkmal Zylinderform und auch das Prüfmerkmal Durchmesser auf. Werden beide Eigenschaften in den erläuterten Prüfschritten ausgewertet, so wird die Messregel der neuen Messstrategie hinzugefügt oder zur Änderung einer existierenden Messstrategie genutzt, die sich z.B. im ersten Prüfschritt ergibt, wobei dann 5 gleichmäßig verteilte Messbahnen für den Zylinder erzeugt werden.

In einer bevorzugten Ausführungsform wird das in einem nachfolgenden Prüfschritt zu prüfende Prüfkriterium abhängig von mindestens einem bereits geprüften Prüfkriterium festgelegt. Beispielsweise kann das im nachfolgenden Prüfschritt zu prüfende Prüfkriterium derart festgelegt werden, dass bei der Prüfung keine Eigenschaft des Prüfelements ausgewertet wird, die bereits in einem vorangegangenen Prüfschritt ausgewertet wurde bzw. bei der Auswertung berücksichtigt wurde. Mit anderen Worten kann in einem nachfolgenden Prüfschritt das zu prüfende Kriterium derart festgelegt werden, dass zur Auswertung keine unzulässige Eigenschaft berücksichtigt wird, wobei eine unzulässige Eigenschaft in Abhängigkeit einer vorbestimmten Zuordnung zwischen mindestens einer bereits geprüften Eigenschaft und mindestens einer unzulässigen Eigenschaft bestimmt werden kann.

Beispielsweise kann somit sichergestellt werden, dass eine Prüfung der Durchmessergröße (Eigenschaft des Prüfelements) nicht als Prüfkriterium festgelegt wird, wenn in vorangegangenen Prüfschritten eine Länge und ein Verhältnis von Länge zu Durchmesser ausgewertet wurden. Die vorbestimmte Zuordnung kann hierbei beispielsweise durch einen Nutzer vorgegeben sein und in einer Speichereinrichtung, z.B. in Form einer Datenbank, abrufbar gespeichert sein.

Alternativ oder kumulativ wird das in einem nachfolgenden Prüfschritt zu prüfende Prüfkriterium abhängig von einem Ergebnis der Prüfung mindestens eines bereits geprüften Prüfkriteriums festgelegt. Beispielsweise können für verschiedene Ergebnisse der Prüfung verschiedene zu prüfende Eigenschaften festgelegt werden, die in einem nachfolgenden Prüfschritt zu prüfen sind. Auch können für verschiedene Ergebnisse verschiedene Soll-Größen für die Prüfung im nachfolgenden Prüfschritt festgelegt werden. Wird beispielsweise in einem vorangegangenen Prüfschritt bestimmt, dass die Länge eines Zylinders kleiner als der Durchmesser des Zylinders ist, so kann in einem nachfolgenden Prüfschritt geprüft werden, ob der Durchmesser kleiner als ein erster vorbestimmter Wert oder kleiner als ein zweiter vorbestimmter Wert ist. Ist jedoch die Länge größer als oder gleich dem Durchmesser, so kann in einem nachfolgenden Prüfschritt beispielsweise geprüft werden, ob der Durchmesser kleiner als ein dritter vorbestimmter Wert oder kleiner als ein vierter vorbestimmter Wert ist, wobei der erste, zweite, dritte und vierte Wert sich jeweils voneinander unterscheiden.

Beispielsweise kann in einem nachfolgenden Prüfschritt das zu prüfende Kriterium derart festgelegt werden, dass zur Auswertung keine unzulässige Eigenschaft berücksichtigt wird, wobei eine unzulässige Eigenschaft in Abhängigkeit einer vorbestimmten Zuordnung zwischen dem Ergebnis der Prüfung eines bereits geprüften Prüfkriteriums und mindestens einer unzulässigen Eigenschaft bestimmt werden kann.

Das Sicherstellen der vorgeschlagenen Art der Festlegung kann insbesondere erfolgen, indem einem Nutzer nur solche Prüfkriterien bei der Festlegung angeboten bzw. zur Auswahl vorgeschlagen werden, beispielsweise durch die vorhergehend erläuterte Datenverarbeitungseinrichtung, die die Erfüllung der genannten Abhängigkeit von bereits geprüften Prüfkriterien sicherstellen. Im vorgenannten Beispiel kann beispielsweise dem Nutzer kein Vorschlag zur Festlegung eines durchmessergrößenabhängigen Prüfkriteriums gemacht werden.

Weiter ist es auch vorstellbar, dass die Messregel, insbesondere die Werte eines Parameters zur Vermessung des Prüfelements, abhängig von mindestens einem bereits geprüften Prüfkriterium und/oder abhängig von einem Ergebnis der Prüfung mindestens eines bereits geprüften Prüfkriteriums festgelegt wird. Insbesondere können festlegbare Werte eines Parameters zur Vermessung abhängig von mindestens einem bereits geprüften Prüfkriterium und/oder abhängig von einem Ergebnis der Prüfung mindestens eines bereits geprüften Prüfkriteriums sein. Z.B. ist es vorstellbar, dass einem Nutzer nur solche Messregeln zur Festlegung angeboten bzw. zur Auswahl vorgeschlagen werden, die zulässige Messregeln sind, wobei zulässige Messregeln in Abhängigkeit einer vorbekannten Zuordnung von zulässigen Messregeln zu einem Ergebnis der Prüfung mindestens eines bereits geprüften Prüfkriteriums und/oder einer vorbekannten Zuordnung von zulässigen Messregeln zu einem bereits geprüften Prüfkriterium bestimmt wird. Auch diese vorbekannte Zuordnung kann abrufbar gespeichert sein, beispielsweise in Form einer Datenbank, und zum Vorschlagen bzw. Anbieten ausgewertet werden, beispielsweise mittels der erläuterten Datenverarbeitungseinrichtung. Hierdurch kann in vorteilhafter Weise sichergestellt werden, dass keine unzulässigen Messparameter zur Verwendung in der Messstrategie oder Messparameter, die zu einer reduzierten Messgüte führen, festgelegt werden.

In einer weiteren Ausführungsform ist ein Prüfelement eine Zylinderform, eine Kreisform, eine Kegelform, eine Kugelform, eine Torusform, eine zweidimensionale Gerade, ein Langloch, eine Ebene, eine Symmetrieebene oder eine Rechteckform. Insbesondere kann also das Prüfelement ein Element mit einer der beschriebenen Formen des Messobjekts sein. Hierdurch ergibt sich in vorteilhafter Weise eine einfache Zuordnung von zu prüfenden Eigenschaften und somit eine zuverlässige Prüfung des Messobjekts mittels der zu bestimmenden Messstrategie.

Bei einer weiteren Ausführungsform ist eine Eigenschaft eines Prüfelements eine Durchmessergröße, eine weitere Durchmessergröße, eine Längengröße, eine Breitengröße, ein Verhältnis von Länge zu Durchmesser, ein Verhältnis von Länge zu Breite, eine Distanzgröße, eine Winkelgröße, eine Innen- oder Außenkennung, die Zugehörigkeit zu einer Prüfmerkmalsgruppe oder die Zugehörigkeit zu einem Prüfmerkmalstyp.

Wie vorhergehend erläutert, kann ein Prüfelement hierbei nicht alle der genannten Eigenschaften aufweisen. So kann die Eigenschaft der weiteren Durchmessergröße nur bei solchen Prüfelementen vorhanden sein, die zwei unterscheidbare Durchmessergrößen aufweisen, beispielsweise bei einem Torus.

Weiter kann eine Durchmessergröße als zu prüfende Eigenschaft nur für die Prüfelemente Kreisform, Zylinderform, Kegelform eine Kugelform oder Torus zulässig sein. Weiter kann eine Längengröße als zu prüfende Eigenschaft nur für die Prüfelemente Zylinderform, Kegelform, 2D-Gerade, Langloch, Ebene, Symmetrieebene oder Rechteckform zulässig sein. Weiter kann eine Breitengröße als zu prüfende Eigenschaft nur für die Prüfelemente Langloch, Ebene, Symmetrieebene oder Rechteckform zulässig sein. Weiter kann das Verhältnis von Länge zu Durchmesser als zu prüfende Eigenschaft nur für die Prüfelemente Zylinderform, Kegelform zulässig sein. Weiter kann das Verhältnis von Länge zu Breite als zu prüfende Eigenschaft nur für die Prüfelemente Langloch, Ebene, Symmetrieebene oder Rechteckform zulässig sein. Weiter kann eine Distanzgröße als zu prüfende Eigenschaft nur für das Prüfelement Symmetrieebene zulässig sein. Weiter kann eine Größe des Kegelwinkels als zu prüfende Eigenschaft nur für das Prüfelement Kegelform zulässig sein. Weiter kann die Innenkennung/Außenkennung als zu prüfende Eigenschaft nur für die Prüfelemente Kreisform, Zylinderform, Kegelform, Langloch, Symmetrieebene, Kugelform, Torus oder Rechteckform zulässig sein.

Eine Innenkennung ist eine Eigenschaft, die ein Element wie z.B. eine Bohrung aufweist. Eine Außenkennung ist eine Eigenschaft, die ein Element wie beispielsweise eine Welle aufweist. So kann beispielsweise eine Bohrung als auch eine Welle als Zylinderform klassifiziert werden, wobei jedoch die Bohrung als Eigenschaft eine Innenkennung und die Welle als Eigenschaft eine Außenkennung aufweist und verschiedene Regeln zur Vermessung der Bohrung und der Welle anzuwenden sind, insbesondere aufgrund der im Vergleich zu einem Element mit Außenkennung in der Regel schwierigeren Zugänglichkeit eines Elements mit Innenkennung, beispielsweise durch einen taktilen Sensor.

Die Prüfelemente können hierbei in Prüfmerkmalsgruppen kategorisiert sein. Ein Prüfelement kann beispielsweise einer Prüfmerkmalsgruppe zugehörig sein, wenn mindestens eine oder aber mehrere oder aber alle der nachfolgenden Bedingungen erfüllt sind: Formbedingung, Positionsbedingung, Größenbedingung, Referenzbedingung. Die Formbedingung kann erfüllt sein, wenn das Prüfelement eine oder mehrere der nachfolgend erläuterten Eigenschaften aufweist: Rundheit, Rundheit in einem bestimmten Winkelbereich, Welligkeit, Ebenheit, Ebenheit in Bezug auf ein weiteres Prüfelement, Geradheit, Geradheit in Bezug auf ein weiteres Prüfelement, Zylinderform, Form, Kurvenform, Flächenform, Linienform.

Eine Positionsbedingung kann erfüllt sein, wenn das Prüfelement mindestens eine der nachfolgenden Eigenschaften aufweist: ermittelbare oder messbare Position, Koaxialität zu einer vorbestimmten Referenzachse, Konzentrizität, Rechtwinkligkeit, Parallelität zu einer vorgegebenen Referenz, Symmetrie bezüglich einer vorgegebenen Referenz, Neigung und weitere Eigenschaft.

Die Größenbedingung kann erfüllt sein, wenn das Prüfelement mindestens eine der nachfolgend aufgeführten messbaren Eigenschaften aufweist: Durchmesser, Radius, Länge, Breite, Kegelwinkel, halber Kegelwinkel, Lotlänge, Distanz zu einer Symmetrieebene, Punktabstand.

Die Referenzbedingung kann erfüllt sein, wenn das Prüfelement die Eigenschaft eines Bezugselements für zumindest eine Koordinatenrichtung für eine Flächenform, eine Linienform, eine Position oder eine Koaxialität aufweist.

Ist keine der vorhergehend erläuterten Bedingungen erfüllt, so kann das Prüfelement als zu einer Restgruppe zugehörig klassifiziert werden.

Die Gruppenzugehörigkeit kann in einem Prüfkriterium geprüft werden, wobei dann auch eine gruppenzugehörigkeitsspezifische Messregel festgelegt werden kann.

Ein Prüfelement kann auch einem Prüfmerkmalstyp zugeordnet sein bzw. als Prüfmerkmalstyp kategorisiert werden. Ein Prüfelement kann beispielsweise einem Prüfmerkmalstyp zugeordnet sein, wenn das Prüfelement es mindestens eine der nachfolgend erläuterten messbaren Eigenschaften aufweist: Rundheit, Welligkeit, Ebenheit, Geradheit, Zylinderform, Kurvenform, Neigung. Selbstverständlich sind noch andere Eigenschaften vorstellbar.

Weitere Eigenschaften für die Erfüllung der Formbedingung, der Positionsbedingung, der Größenbedingung und der Referenzbedingung kann der Fachmann den einschlägigen Normen entnehmen, beispielsweise der Norm DIN EN ISO 1101, Ausgabe 2017-09.

Weist das Prüfelement keine dieser Eigenschaften auf, so kann es dem Prüfmerkmalstyp Rest zugeordnet werden.

Die Typzugehörigkeit kann in einem Prüfkriterium geprüft werden, wobei dann auch eine typzugehörigkeitsspezifische Messregel festgelegt werden kann.

Hierdurch ergibt sich in vorteilhafter Weise die Erstellung einer Messstrategie der Messung möglichst gut messbarer Eigenschaften von Prüfmerkmalen, wodurch die Messgüte der gemäß der zu bestimmenden Messstrategie durchgeführten Vermessung in vorteilhafter Weise erhöht wird.

In einer weiteren Ausführungsform wird die Prüfung, ob eine anwendbare Messregel in der Messregel-Menge existiert, abhängig von mindestens zwei verschiedenen Eigenschaften des Prüfelements durchgeführt, wobei die verschiedenen Eigenschaften sequenziell geprüft werden. Diesbezüglich kann auf die Erläuterung zur Festlegung von Messregeln und den einer Messregel zugeordneten Prüfkriterien zu deren Anwendung verwiesen werden. Hierdurch ergibt sich in vorteilhafter Weise eine zeitlich schnelle und einfach realisierbare Prüfung, ob in der Messregel-Menge eine anwendbare Messregel existiert, wobei die Messregeln der Messregel-Menge wie vorhergehend erläutert festgelegt sind.

In einer weiteren Ausführungsform werden die in einem nachfolgenden Prüfschritt zu prüfende Eigenschaft/zu prüfenden Eigenschaften abhängig von mindestens einer bereits geprüften Eigenschaft und/oder abhängig von einem Ergebnis der Prüfung mindestens einer bereits geprüften Eigenschaft bestimmt. Diesbezüglich kann ebenfalls auf die Erläuterungen zu der Festlegung von Messregeln und zu deren Anwendbarkeit zu prüfenden Prüfkriterien verwiesen werden.

Es ist z.B. möglich, dass für ein Prüfelement, insbesondere einen Zylinder oder Kegel, als zu prüfende Eigenschaft keine Durchmessergröße bestimmbar ist, wenn bereits die Längengröße oder das Verhältnis von Länge zu Durchmesser als Eigenschaft geprüft wurde. Weiter ist es möglich, dass für ein Prüfelement, insbesondere einen Zylinder oder Kegel, als zu prüfende Eigenschaft keine Längengröße bestimmbar ist, wenn bereits die Durchmessergröße oder das Verhältnis von Länge zu Durchmesser als Eigenschaft geprüft wurde. Weiter ist es möglich, dass für ein Prüfelement, insbesondere eine Ebene, eine Symmetrie-Ebene oder ein Rechteck, als zu prüfende Eigenschaft keine Längengröße bestimmbar ist, wenn bereits die Breitengröße oder das Verhältnis von Länge zu Breite als Eigenschaft geprüft wurde. Weiter ist es möglich, dass für ein Prüfelement, insbesondere eine Ebene, eine Symmetrie-Ebene oder ein Rechteck, als zu prüfende Eigenschaft keine Breitengröße bestimmbar ist, wenn bereits die Längengröße oder das Verhältnis von Länge zu Breite als Eigenschaft geprüft wurde. Weiter ist es möglich, dass für ein Prüfelement, insbesondere einen Zylinder oder Kegel, als zu prüfende Eigenschaft kein Verhältnis von Länge zu Durchmesser bestimmbar ist, wenn bereits die Durchmessergröße oder die Längengröße als Eigenschaft geprüft wurde. Weiter ist es möglich, dass für ein Prüfelement, insbesondere eine Ebene, eine Symmetrie-Ebene oder ein Rechteck, als zu prüfende Eigenschaft kein Verhältnis von Länge zu Breite bestimmbar ist, wenn bereits die Längengröße oder die Breitengröße als Eigenschaft geprüft wurde.

Entsprechend können auch die Messregeln und die zur deren Anwendbarkeit auszuwertenden Prüfkriterien festgelegt sein.

Hierdurch wird in vorteilhafter Weise die Bestimmung einer Messstrategie beschleunigt, da zeitlich schnell die Messregel-Menge auf anwendbare Messregeln geprüft werden kann.

In einer weiteren Ausführungsform wird ein Prüfelement modellbasiert bestimmt. Alternativ wird das Messobjekt vermessen und das Prüfelement durch Auswertung der Messergebnisse bestimmt. Dies und entsprechende Vorteile wurden vorhergehend bereits erläutert.

In einer weiteren Ausführungsform wird das Messobjekt gemäß der neuen oder geänderten Messstrategie vermessen und eine Messgüte der Vermessung bestimmt wird. Zur Bestimmung einer erneut geänderten Messstrategie wird mindestens ein Prüfelement des Messobjekts bestimmt. Weiter wird für das Prüfelement - wie vorhergehend erläutert - automatisiert geprüft, ob eine anwendbare Messregel in einer Messregel-Menge von vorab festgelegten Messregeln existiert, wobei die prüfelementspezifische Messregel der neuen oder geänderten Messstrategie geändert wird, wenn diese Messregel auf das Prüfelement anwendbar ist, wobei die Prüfung in Abhängigkeit der Messgüte erfolgt.

Beispielsweise kann ein Prüfkriterium derart festgelegt werden, dass geprüft wird, ob die Messgüte höher als eine vorbestimmte Soll-Mindestmessgüte ist, insbesondere mehr als ein vorbestimmtes Maß. Ist dies der Fall, so kann die entsprechende Messregel derart festgelegt werden, dass sich die zur Vermessung des Messobjekts gemäß der erneut geänderten Messstrategie benötigte Zeitdauer und/oder der zur Vermessung des Messobjekts gemäß der erneut geänderten Messstrategie benötigte Rechenaufwand und/oder die zur Vermessung des Messobjekts gemäß der erneut geänderten Messstrategie benötigte Datenspeicherkapazität im Vergleich zur bisherigen Messstrategie verringert. Insbesondere kann die Messregel derart festgelegt werden, dass sich die Messgüte verringert. Das Festlegen der Messregel kann erfolgen, indem mindestens ein festlegbarer Parameter z.B. durch Quantifizierung festgelegt wird.

Insbesondere ermöglicht diese Ausführungsform während der Vermessung, insbesondere während eines Messablaufs oder nach einem Messablauf, dynamisch Veränderungen der Messstrategie durchzuführen. Hierdurch wird in vorteilhafter Weise ermöglicht, das Messverfahren, welches durch die Messstrategie festgelegt ist, an das Messobjekt und seine Produktionsgüte anzupassen. Weiter wird auch eine Anpassung an die Koordinatenmesseinrichtung und die verwendete Sensorik ermöglicht. Auch kann durch diese Ausführungsform in vorteilhafter Weise eine zeitlich schnellere Vermessung des Messobjekts erreicht werden, wodurch sich auch die Prozessdauer eines Prozesses, in dem die Vermessung eingebunden ist, beispielsweise eine Qualitätsprüfung, verkürzt. Benötigt die Vermessung weniger Rechenaufwand, so können in vorteilhafter Weise weniger leistungsfähige Elemente, insbesondere Recheneinrichtungen, eingesetzt werden, die zur Erzeugung und/oder Auswertung der Messpunkte eingesetzt werden. Da diese in der Regel billiger und auch weniger Bauraumanforderungen aufweisen, kann somit eine Reduktion von Herstellungskosten und gegebenenfalls Bauraumbedarf der Koordinatenmesseinrichtung erreicht werden. Auch trägt die Reduktion des Rechenaufwands in vorteilhafterweise zu einer zeitlich schnelleren Vermessung, also einer kürzeren Messdauer, bei. Ähnliches gilt für die Reduktion der Datenspeicherkapazität, durch die ähnliche Vorteile wie bei der Reduktion des Rechenaufwands erzielt werden können.

Als Messgüte kann z.B. ein Messgüteparameter bestimmt werden, der die Messgüte repräsentiert. Dieser kann z.B. eine Relation zwischen der Messunsicherheit und einer vorbekannten Fertigungstoleranz sein. Auch kann als Messgüte eine Größe bestimmt werden, die die Genauigkeit, die Wiederholbarkeit, die Reproduzierbarkeit, die Linearität und/oder die Stabilität der Vermessung gemäß der Messstrategie repräsentiert. Zur Bestimmung einer die Messgüte repräsentierenden Größe kann ein GR&R-Test oder ein Test gemäß VDA Band 5 durchgeführt werden.

Es ist selbstverständlich auch möglich, dass ein Prüfkriterium derart festgelegt wird, dass geprüft wird, ob die Messgüte geringer als eine vorbestimmte Soll-Mindestmessgüte ist. Ist dies der Fall, so kann die entsprechende Messregel derart festgelegt werden, dass sich die Messgüte zur Vermessung des Messobjekts gemäß der erneut geänderten Messstrategie voraussichtlich erhöht, insbesondere die zur Vermessung gemäß der erneut geänderten Messstrategie benötigte Zeitdauer und/oder der zur Vermessung des Messobjekts gemäß der erneut geänderten Messstrategie benötigte Rechenaufwand und/oder die zur Vermessung des Messobjekts gemäß der erneut geänderten Messstrategie benötigte Datenspeicherkapazität im Vergleich zur bisherigen Messstrategie erhöht. Hierzu kann auch die entsprechende Auswirkung der Veränderung auf die Messgüte geschätzt werden, z.B. auf Basis eines vorbekannten Zusammenhangs zwischen der Veränderung und der Auswirkung. Weiter kann festgelegt werden, dass keine Änderung der Messregel erfolgt, wenn die Messgüte gleich der vorbestimmten Soll-Mindestmessgüte ist oder nicht mehr als das vorbestimmte Maß höher als diese ist.

Es ist weiter möglich, dass die wie vorgeschlagen bestimmte Messstrategie nach automatisiert geprüft wird, insbesondere die erstellten Messregeln auf Anwendbarkeit. So kann z.B. geprüft werden, ob mit den Messregeln der Messstrategie ein Zustand auftritt, in dem kein Kontakt eines taktilen Sensors mit dem Messobjekt erfolgt, obwohl das Messobjekt eigentlich kontaktiert sein sollte. Ein problematischer Zustand kann einem Nutzer durch Anzeige eines Warnsymbols angezeigt werden. Ebenfalls können Informationen zum problematischen Zustand angezeigt werden.

Weiter vorgeschlagen wird eine Vorrichtung zur Bestimmung einer Messstrategie zur Vermessung eines Messobjekts, wobei die Vorrichtung mindestens eine Datenverarbeitungseinrichtung umfasst. Diese Datenverarbeitungseinrichtung kann hierbei ein Computer oder Teil eines Computers sein. Weiter ist mindestens ein Prüfelement des Messobjekts bestimmbar, insbesondere mittels der Datenverarbeitungseinrichtung. Hierzu kann diese beispielsweise Modellinformationen, beispielsweise CAD-Informationen, auswerten, wobei diese über eine geeignete Schnittstelle der Datenverarbeitungseinrichtung eingelesen werden können. Weiter wird für das Prüfelement mittels der Datenverarbeitungseinrichtung automatisiert geprüft, ob eine anwendbare Messregel in einer Messregel-Menge von vorab festgelegten Messregeln existiert. Die Messregel einer neuen Messstrategie wird hinzugefügt oder die prüfelementspezifische Messregel einer existierenden Messstrategie geändert, wenn diese Messregel auf das Prüfelement anwendbar ist. Die neue Messstrategie oder die geänderte existierende Messstrategie kann dann von der Datenverarbeitungseinrichtung gespeichert werden und abrufbar zur Verfügung gestellt werden.

Es ist vorstellbar, dass die Datenverarbeitungseinrichtung Teil einer Recheneinrichtung ist, die zur Steuerung einer Koordinatenmesseinrichtung zur Vermessung eines Messobjekts auf Grundlage einer Messstrategie dient. Dann kann die Vermessung des Messobjekts auf Grundlage der erfindungsgemäß bestimmten Messstrategie durchgeführt werden.

Allerdings ist es auch vorstellbar, dass die neue Messstrategie bzw. die geänderte existierende Messstrategie an die Steuereinrichtung einer Koordinatenmesseinrichtung übermittelt und dann von dieser zur Vermessung des Messobjekts genutzt wird.

Die Vorrichtung kann weiter eine Speichereinrichtung zur Speicherung der vorab festgelegten Messregeln sowie des mindestens einen Prüfkriteriums zu deren Anwendbarkeit umfassen.

Erfindungsgemäß werden die Messregeln der Messregel-Menge bestimmt, indem für ein Prüfelement eine Messregel sowie mindestens ein Prüfkriterium zu deren Anwendbarkeit durch einen Nutzer oder (teil-)automatisiert festgelegt werden, wobei die Messregel mindestens einen Parameter zur Vermessung des Prüfelements festlegt.

Weiter kann die Vorrichtung mindestens eine Eingabeeinrichtung zur Eingabe von Messregelparametern/-informationen sowie zur Eingabe von Parametern/Informationen des Prüfkriteriums umfassen. Weiter kann die Vorrichtung mindestens eine Anzeigeeinrichtung zur Anzeige der vorhergehend erläuterten Informationen umfassen.

Es ist weiter vorstellbar, dass die Vorrichtung mindestens eine Einrichtung zur Erfassung von Umgebungsbedingungen, beispielsweise ein Temperatursensor, und/oder eine Einrichtung zur Bestimmung einer vorbestimmten Toleranz und/oder eine Einrichtung zur Bestimmung eines Messgerätetyps und/oder eine Einrichtung zur Bestimmung eines Sensortyps und/oder eine Einrichtung zur Bestimmung eines Bauzustands des Messobjekts umfasst.

Die Vorrichtung ist hierbei derart konfiguriert, dass ein Verfahren zur Bestimmung einer Messstrategie zur Vermessung des Messobjekts gemäß einer der in dieser Offenbarung erläuterten Ausführungsformen mittels der Vorrichtung durchführbar ist. Somit kann auf die entsprechend erläuterten Vorteile verwiesen werden. Die Vorrichtung kann hierbei Teil einer Koordinatenmesseinrichtung sein.

Weiter wird ein Verfahren zur Vermessung eines Messobjekts beschrieben, wobei in diesem Verfahren eine Messstrategie zur Vermessung eines Messobjekts gemäß einer der in dieser Offenbarung erläuterten Ausführungsformen bestimmt wird, wobei dann die Vermessung des Messobjekts auf Grundlage der derart bestimmten Messstrategie erfolgt. Insbesondere kann der Betrieb einer Koordinatenmesseinrichtung in Abhängigkeit von durch die Messstrategie festgelegten Messparametern gesteuert werden.

Weiter beschrieben wird eine Koordinatenmesseinrichtung mit einer Vorrichtung zur Bestimmung einer Messstrategie zur Vermessung eines Messobjekts gemäß einer der in dieser Offenbarung erläuterten Ausführungsformen. Diese Koordinatenmesseinrichtung kann das vorhergehend erläuterte Verfahren zur Vermessung des Messobjekts anhand der wie vorgeschlagen bestimmten Messstrategie durchführen. Somit kann die Koordinatenmesseinrichtung entsprechend konfiguriert sein.

Weiter vorgeschlagen wird ein Programm, welches, wenn es auf oder durch einen Computer ausgeführt wird, den Computer veranlasst, einen, mehrere oder alle Schritte eines Verfahrens zur Bestimmung einer Messstrategie zur Vermessung eines Messobjekts gemäß einer der in dieser Offenbarung erläuterten Ausführungsformen durchzuführen. Alternativ oder kumulativ wird ein Programmspeichermedium oder Computerprogrammprodukt beschrieben, auf oder in dem das Programm gespeichert ist, insbesondere in einer nicht vorübergehenden, z.B. in einer dauerhaften, Form. Alternativ oder kumulativ wird ein Computer beschrieben, der dieses Programmspeichermedium umfasst. Weiter alternativ oder kumulativ wird ein Signal beschrieben, beispielsweise ein digitales Signal, welches Informationen kodiert, die das Programm repräsentieren und welches Code-Mittel umfasst, die adaptiert sind, einen, mehrere oder alle Schritte des in dieser Offenbarung dargestellten Verfahrens zur Bestimmung einer Messstrategie durchzuführen. Das Signal kann ein physikalisches Signal, z.B. ein elektrisches Signal, sein, welches insbesondere technisch oder maschinell erzeugt wird. Das Programm kann den Computer auch dazu veranlassen, eine Benutzung des Messobjekts gemäß der Messstrategie, beispielsweise mittels einer Koordinatenmesseinrichtung, auszuführen. Weiter kann das Verfahren zur Bestimmung einer Messstrategie ein computerimplementiertes Verfahren sein. So können z.B. ein, mehrere oder alle Schritte des Verfahrens durch einen Computer ausgeführt werden. Eine Ausführungsform für das computerimplementierte Verfahren ist die Benutzung des Computers zur Durchführung einer Datenverarbeitungsmethode. Der Computer kann z.B. zumindest eine Recheneinrichtung, insbesondere einen Prozessor, und z.B. zumindest eine Speichereinrichtung umfassen, um die Daten, insbesondere technisch, zu verarbeiten, z.B. elektronisch und/oder optisch. Ein Computer kann hierbei jede Art von Datenverarbeitungseinrichtung sein. Ein Prozessor kann ein halbleiterbasierter Prozessor sein.

Hierdurch ergibt sich in vorteilhafter Weise ein Programm, durch welches das vorhergehend erläuterte Verfahren mit den bezüglich gekannten Vorteilen durchführbar ist.

Die Erfindung wird anhand von Ausführungsbeispielen näher erläutert. Die Figuren zeigen:
- Fig. 1: ein schematisches Flussdiagramm eines erfindungsgemäßen Verfahrens,
- Fig. 2: ein schematisches Flussdiagramm mehrerer Prüfkriterien zur Auswertung der gleichen Eigenschaft,
- Fig. 3: ein schematisches Flussdiagramm der Prüfung verschiedener Eigenschaften eines Prüfelements,
- Fig. 4: eine exemplarische Darstellung einer Nutzeroberfläche eines Strategie-Editor-Moduls,
- Fig. 5: eine schematische Darstellung eines Messobjekts,
- Fig. 6: eine exemplarische Darstellung einer Nutzeroberfläche eines Strategie-Zuweisungs-Moduls und
- Fig. 7: eine schematische Darstellung einer erfindungsgemäßen Vorrichtung.

Nachfolgend bezeichnen gleiche Bezugszeichen Elemente mit gleichen oder ähnlichen technischen Merkmalen.

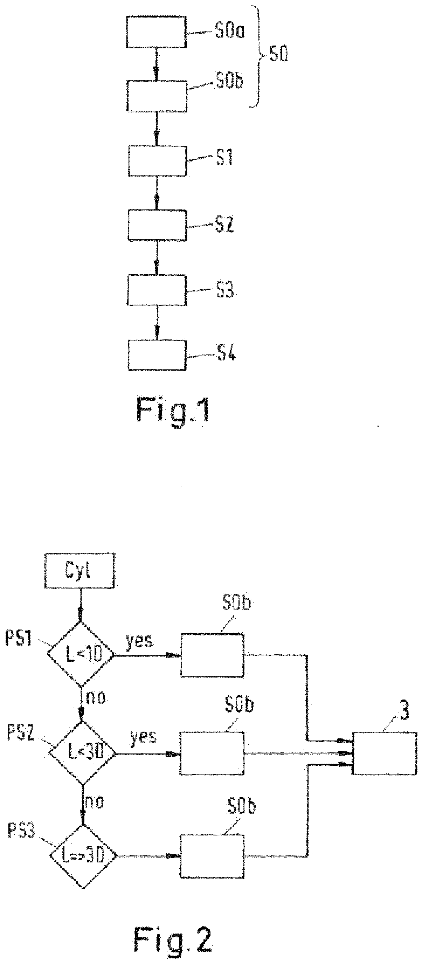

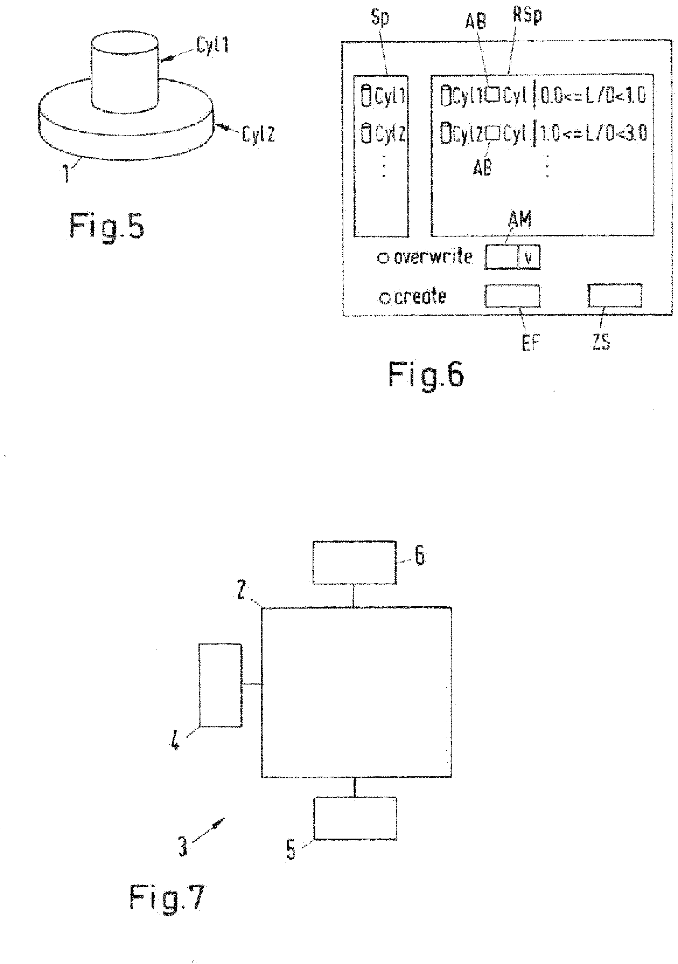

Fig. 1 zeigt ein schematisches Flussdiagramm eines erfindungsgemäßen Verfahrens zur Bestimmung einer Messstrategie zur Vermessung eines Messobjekts 1 (siehe Fig. 5).

In einem Prüfkriterium-Festlegeschritt S0a eines Festlegeschrittes S0 legt der Nutzer oder eine Datenverarbeitungseinrichtung 2 (siehe Fig. 7) in (teil-)automatisierter Weise ein Prüfkriterium zur Anwendbarkeit einer Messregel zur Vermessung eines Prüfelements fest. In einem Messregel-Festlegeschritt S0b wird dann die Messregel festgelegt, die bei Erfüllung des Prüfkriteriums festgelegt wird, z.B. ebenfalls durch einen Nutzer oder in (teil-)automatisierter Weise. Die Sequenz aus dem Prüfkriterium-Festlegeschritt S0a und dem Messregel-Festlegeschritt S0b kann zur Festlegung einer Mehrzahl von Messregeln und ihnen zugeordneten Prüfkriterien wiederholt werden. Es ist jedoch auch möglich, dass zuerst die Messregel und dann das Prüfkriterium zu deren Anwendbarkeit festgelegt wird. Wie vorhergehend erläutert, können diese Festlegeschritte S0a, S0b im Rahmen eines messobjektunabhängigen Aufbaus der Messregel-Menge durchgeführt werden.

Das Prüfkriterium kann insbesondere festgelegt werden, indem eine zu prüfende Eigenschaft des Prüfelements, vorzugsweise eine geometrische Eigenschaft, eine Art der der Prüfung und eine Sollgröße für die Eigenschaft zur Erfüllung des Prüfkriteriums festgelegt wird. Das Prüfkriterium ist dann erfüllt, wenn die Eigenschaft das durch die Art der Prüfung und die Sollgröße festgelegte Kriterium erfüllt.

Der Festlegeschritt S0 kann hierbei zeitlich vor der Durchführung des Verfahrens durchgeführt werden, welches aus der Sequenz eines ersten Schritts S1, eines zweiten Schritts S2 und eines dritten Schritts S3 besteht. Die im Festlegeschritt S0 festgelegten Messregeln und ihnen zugeordnete Prüfkriterien zu deren Anwendbarkeit werden gespeichert und bilden eine Messregel-Menge von vorab festgelegten Messregeln, wobei diesen entsprechende Prüfkriterien zugeordnet sind. Auch kann die Messregel-Menge - wie nachfolgend noch erläutert - im Prüfschritt S2 erweitert werden.

In einem ersten Schritt S1 des vorgeschlagenen Verfahrens, der auch als Bestimmungsschritt bezeichnet werden kann, erfolgt ein Bestimmen mindestens eines Prüfelements eines Messobjekts 1 (siehe Fig. 5).

Im Bestimmungsschritt kann das Prüfelement des Messobjekts 1 modellbasiert bestimmt werden. Dies wurde vorhergehend bereits erläutert. Insbesondere kann ein CAD-Modell geladen werden, wobei aus dem CAD-Modell Prüfelemente des Messobjekts 1 extrahiert werden. Entsprechende Verfahren sind dem Fachmann bekannt. Es ist auch vorstellbar, das Messobjekt 1 zu vermessen und dann auf Basis der Messergebnisse Prüfelemente des Messobjekts 1 zu bestimmen. Hierbei kann eine Auflösung dieser Vermessung gröber sein als die Auflösung der Vermessung mit der wie vorgeschlagen zu bestimmenden Messstrategie.

In einem zweiten Schritt S2, der auch als Prüfschritt bezeichnet werden kann, wird geprüft, ob eine der im Festlegeschritt S0 festgelegten Messregeln der Messregel-Menge auf das Prüfelement anwendbar ist. Hierzu kann mindestens eine, vorzugsweise aber mehrere, Eigenschaft(en) des Prüfelements bestimmt werden, wobei dann in Abhängigkeit der im Festlegeschritt S0 definierten Prüfkriterien geprüft wird, ob alle einer Messregel zugeordneten Prüfkriterien erfüllt sind. Dies ist beispielsweise der Fall, wenn eine oder mehrere Eigenschaften des Prüfelements jeweils einer Soll-Eigenschaft entsprechen oder in einem vorbestimmten Soll-Eigenschaftsbereich liegen.

Wird eine anwendbare Messregel identifiziert, so wird diese in einem dritten Schritt S3, der auch als Hinzufüge- oder Änderungsschritt S3 bezeichnet werden kann, einer neuen Messstrategie hinzugefügt bzw. eine existierende Messstrategie entsprechend geändert.

Wird keine anwendbare Messregel für ein im Bestimmungsschritt ausgewähltes Prüfelement in der Messregel-Menge identifiziert, so kann eine nicht in der Messregel-Menge enthaltenden Messregel als anwendbare Messregel bestimmt werden, insbesondere automatisiert oder teilautomatisiert. So kann z.B. eine Default-Messregel als anwendbare Messregel für das Prüfelement bestimmt werden. Alternativ kann eine anwendbare Messregel basierend auf mindestens einer ähnlichen Messregel der existierenden Messregel-Menge bestimmt werden. Weiter alternativ kann eine anwendbare Messregel in Abhängigkeit mindestens einer Eigenschaft eines Messszenarios bestimmt werden. Weiter alternativ kann eine anwendbare Eigenschaft durch Auswertung von existierenden Messregeln bestimmt werden. Dies wurde vorhergehend erläutert.

Weiter kann die derart bestimmte Messregel der Messregel-Menge hinzugefügt werden. In diesem Fall kann, wie vorhergehend ebenfalls erläutert, mindestens ein Kriterium zu deren Anwendbarkeit bestimmt werden, insbesondere ebenfalls automatisiert oder teilautomatisiert. In diesem Fall wird die Messregel-Menge (teil-)automatisiert erweitert.

In einem vierten (optionalen) Schritt S4 kann dann eine Koordinatenmesseinrichtung (nicht dargestellt) derart angesteuert werden, dass die Vermessung des Messobjekts 1 gemäß der entsprechend festgelegten Messstrategie, die eine oder mehrere Messregeln umfassen kann, durchgeführt wird.

Fig. 2 zeigt ein schematisches Flussdiagramm, welches die Festlegung einer Messregel darstellt.

Hierbei ist das Festlegen für ein zylinderförmiges Prüfelement Cyl dargestellt, also ein Prüfelement, welches eine Zylinderform aufweist.

Hierbei wird festgelegt, dass in einem ersten Prüfschritt PS1 geprüft wird, ob die Länge L des zylinderförmigen Prüfelements kleiner als der Durchmesser D des zylinderförmigen Prüfelements ist. Dies kann in einem Prüfkriterium-Festlegeschritt S0a des Festlegeschritts S0 erfolgen. Ist dies der Fall, so wird entsprechend dem vorhergehend erläuterten Messregel-Festlegeschritt S0b des Festlegeschritts S0 mindestens ein Parameter zur Vermessung des Prüfelements festgelegt, beispielsweise eine Geschwindigkeit einer Relativbewegung zwischen Messobjekt 1 und einem Sensor der Koordinatenmesseinrichtung, welche auch als Scanning-Geschwindigkeit bezeichnet werden kann, sowie die Anzahl von zu erzeugenden Messpunkten entlang einer Zylindermantelfläche sowie ein zu vermessender Winkelbereich.

Weiter wird festgelegt, dass - wenn das Prüfkriterium im ersten Prüfschritt PS1 nicht erfüllt ist - in einem zweiten Prüfschritt PS2 geprüft wird, ob die Länge L kleiner als der dreifache Durchmesser D des zylinderförmigen Prüfelements ist. Dies kann in einem Prüfkriterium-Festlegeschritt S0a des entsprechenden Festlegeschritts S0 erfolgen. Ist dieses Prüfkriterium erfüllt, so wird eine Messregel durch Festlegung entsprechender Parameter zur Vermessung festgelegt, die sich von der Messregel bei Erfüllung des Prüfkriteriums im ersten Prüfschritt PS1 unterscheiden können. Beispielsweise kann die Relativgeschwindigkeit höher, die Anzahl von Messpunkten größer und der zu vermessende Winkelbereich kleiner gewählt werden.

Weiter wird festgelegt, dass, wenn das Prüfkriterium im zweiten Prüfschritt PS2 nicht erfüllt ist, in einem dritten Prüfschritt PS3 geprüft wird, ob die Länge L größer als oder gleich dem dreifachen Durchmesser D des zylinderförmigen Prüfelements ist. Ist dies der Fall, so wird eine entsprechende Messregel durch Festlegung von Parametern zur Vermessung festgelegt, wobei beispielsweise die Scanning-Geschwindigkeit wiederum höher, die Anzahl der Messpunkte wiederum größer und der Winkelbereich wiederum kleiner als bei Erfüllung des Kriteriums im zweiten Prüfschritt PS2 festgelegt werden kann.

Die Festlegung der Prüfkriterien für die dargestellten Folgeschritte PS1, PS2, PS3 sowie die Festlegung der Parameter der Messregel in den entsprechenden Messregeln können hierbei durch einen Nutzer festgelegt werden, insbesondere durch wiederholte Durchführung der Sequenz aus dem Prüfkriterium-Festlegeschritt und dem Messregel-Festlegeschritt S0a, S0b des Festlegeschritts S0. Auch ist es möglich, dass sowohl die Kriterien als auch die Parameter (teil-)automatisiert festgelegt werden.

Die derart festgelegten Messregeln werden einem Regelgenerator 7 zugeführt, der einen entsprechend ausführbaren Code zur Prüfung der Anwendbarkeit erzeugt. Auch kann der Regelgenerator 7 Code-Mittel zur Vermessung des Messobjekts 1 mit den in den entsprechenden Messregeln festgelegten Parametern erzeugen, wobei diese dann die Vermessung des Messobjekts 1 durch die Koordinatenmesseinrichtung ermöglichen, die gemäß den derart erzeugten Code-Mitteln gesteuert werden kann.

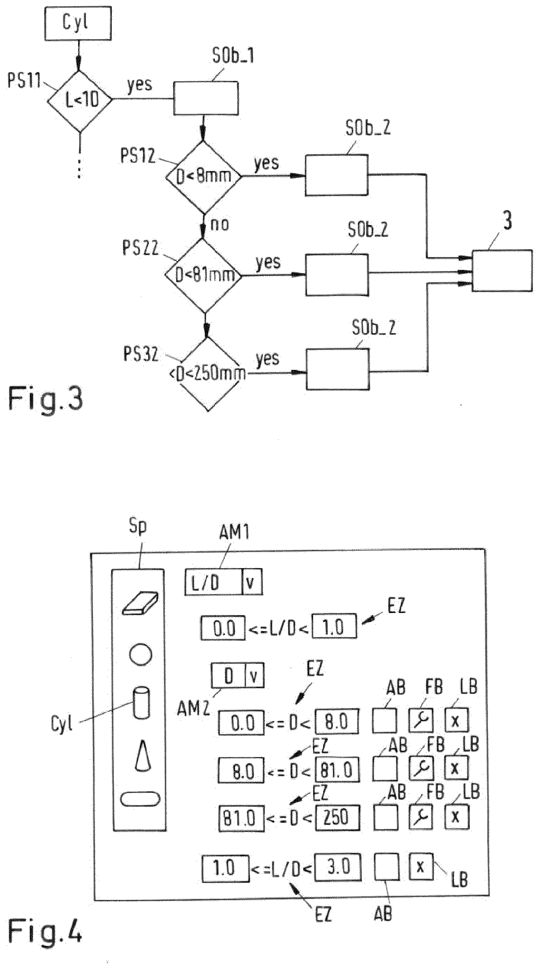

Fig. 3 zeigt ein weiteres schematisches Flussdiagramm des Festlegens von Messregeln und Prüfkriterien, wobei in verschiedenen Prüfschritten verschiedene Eigenschaften des Messobjekts 1 ausgewertet werden.

Hierbei ist das Festlegen für ein zylinderförmiges Prüfelement Cyl dargestellt, also ein Prüfelement, welches eine Zylinderform aufweist.

Für einen ersten Prüfschritt PS11 zur Prüfung einer ersten Eigenschaft, nämlich des Verhältnis von Länge L zu Durchmesser D, wird festgelegt, dass eine Prüfung erfolgt, ob die Länge L des zylinderförmigen Prüfelements kleiner als der Durchmesser D des zylinderförmigen Prüfelements ist. Ist dieses Merkmal erfüllt, so wird in einem ersten Teilschritt S0b_1 eines Messregel-Festlegeschritts S0b festgelegt, dass eine Vermessung des zylinderförmigen Prüfelements mit zwei voneinander verschiedenen Kreisbahnen erfolgt. Hiernach wird für einen ersten Prüfschritt PS12 zur Prüfung einer weiteren Eigenschaft festgelegt, dass geprüft wird, ob der Durchmesser D kleiner als 8 mm ist. Ist dieses Prüfkriterium erfüllt, so werden in einem weiteren Teilschritt S0b_2 des Messregel-Festlegeschritts S0b weitere Parameter zur Vermessung des Prüfelements, beispielsweise die Scanning-Geschwindigkeit, die Anzahl der Messpunkte sowie der zu vermessende Winkelbereich festgelegt.

Weiter wird festgelegt, dass bei Nichterfüllung des im ersten Prüfschritt PS12 geprüften Kriteriums in einem zweiten Prüfschritt P22 der weiteren Eigenschaft geprüft wird, ob der Durchmesser D kleiner als 81 mm ist. Ist dieses Kriterium erfüllt, so werden in einem alternativen Teilschritt S0b_2 des Messregel-Festlegeschritts S0b die genannten weiteren Parameter festgelegt, wobei jedoch anderen Werte als bei der Erfüllung des Kriteriums im ersten Prüfschritt P12 der weiteren Eigenschaft festgelegt werden.

Weiter wird festgelegt, dass im Falle der Nichterfüllung dieses im zweiten Prüfschritt PS22 geprüften Kriteriums in einem dritten Prüfschritt P23 der weiteren Eigenschaft ein weiteres Prüfkriterium ausgewertet wird, nämlich ob der Durchmesser größer als 250 mm ist. Ist dies erfüllt, so werden in einem alternativen Teilschritt S0b_2 des Messregel-Festlegeschritts S0b die genannten weiteren Parameter festgelegt, wobei jedoch anderen Werte als bei der Erfüllung des Kriteriums im ersten Prüfschritt P12 und bei der Erfüllung des Kriteriums im zweiten Prüfschritt P22 der weiteren Eigenschaft festgelegt werden.

Ist das Prüfkriterium im ersten PS11 der ersten Eigenschaft nicht erfüllt, so werden entsprechende weitere Prüfschritte mit Prüfkriterien festgelegt, bei deren Erfüllung dann eine Messregel zumindest teilweise festgelegt wird und/oder eine Festlegung von Prüfschritten mit Prüfkriterien zur Prüfung der weiteren Eigenschaften festgelegt werden.

Somit ergibt sich eine Baumstruktur, durch die Prüfkriterien und entsprechende Messregeln festgelegt sind.

Fig. 4 zeigt eine exemplarische Darstellung einer Nutzeroberfläche eines Strategie-Editor-Moduls. In einer Prüfelementspalte Sp sind verschiedene Prüfelemente dargestellt, die durch geometrische Eigenschaften des Prüfelements charakterisiert sind. So sind in dieser Spalte Sp ein Kreis, ein Zylinder Cyl, ein Kegel, ein Langloch sowie ein Rechteck dargestellt.

Durch die grafische Darstellung werden diese Prüfelemente dem Nutzer zur Auswahl angeboten. Der Nutzer kann ein Prüfelement auswählen, z.B. aus einer geeigneten Eingabeeinrichtung, z.B. einer Maus.

Im in Fig. 4 dargestellten Ausführungsbeispiel wird angenommen, dass ein Zylinder Cyl als Prüfelement ausgewählt wurde.

Im ersten Auswahlmenü AM1 kann der Nutzer dann die in einem oder mehreren Prüfkriterien zu prüfende erste Eigenschaft auswählen, wobei in dem in Fig. 4 dargestellten Ausführungsbeispiel exemplarisch ein Verhältnis von Länge L zu Durchmesser D eines zylinderförmigen Prüfelements als zu prüfende Eigenschaft ausgewählt ist.

Durch einen Pfeil am rechten Rand des Auswahlmenüs AM1 ist symbolisiert, dass weitere Eigenschaften zur Auswahl angeboten sind. Hierbei können jedoch nur diejenigen Eigenschaften zur Auswahl angeboten werden, die prüfelementspezifische Eigenschaften sind.

In einer eingerückten Eingabezeile EZ kann der Nutzer dann Werte für die Auswertung des Prüfkriteriums quantifizieren, durch die das Verhältnis von Länge L zu Durchmesser D ausgewertet werden. So ist dargestellt, dass durch Eingabe von entsprechenden Werten in der Eingabezeile EZ geprüft wird, ob das Verhältnis von Länge L zu Durchmesser D größer als oder gleich 0 und kleiner als 1,0 ist. Weiter dargestellt ist eine weitere Eingabezeile zur Quantifizierung eines weiteren Prüfkriterium zur Prüfung der ersten Eigenschaft, wobei durch Eingabe entsprechender Werte festgelegt ist, dass geprüft wird, ob das Verhältnis von Länge L zu Durchmesser D größer als oder gleich 1,0 kleiner als 3,0 ist.

Weiter kann eine weitere zu prüfende Eigenschaft durch den Nutzer festgelegt werden, insbesondere mittels eines zweiten Auswahlmenüs AM2. In dem in Fig. 4 dargestellten Ausführungsbeispiel ist diese weitere Eigenschaft der Durchmesser D des zylinderförmigen Prüfelements. Entsprechend den vorherigen Ausführungen können dann durch Eingabe von Werten in ein oder mehreren Eingabezeilen EZ ein oder mehrere Prüfkriterien festgelegt werden, die den Durchmesser D zur Auswertung benötigen. In dem in Fig. 4 dargestellten Ausführungsbeispiel sind exemplarisch drei derartige Prüfkriterien festgelegt, die in aufeinanderfolgenden Prüfschritten geprüft werden können. Für die Auswertung eines erstes Prüfkriterium ist festgelegt, dass evaluiert wird, ob der Durchmesser größer als oder gleich 0 und kleiner als 8,0 mm ist. Für ein zweites Prüfkriterium ist festgelegt, dass evaluiert wird, ob der der Durchmesser größer als oder gleich 8,0 mm und kleiner als 81,0 mm ist. Für ein drittes Prüfkriterium ist festgelegt, dass geprüft wird, ob der Durchmesser D größer als oder gleich 81,0 mm und kleiner als 250 mm ist.

Weiter dargestellt sind Aktivierungsboxen AB in einer Eingabezeile EZ, die durch einen Nutzer, beispielsweise mittels einer geeigneten Eingabeeinrichtung, aktiviert werden können, um die Verwendung des durch die Werte dieser Eingabezeile EZ festgelegten Prüfkriteriums bei der Prüfung auf anwendbare Messregeln zu aktivieren.

Durch eine Festlegebox FB in einer Eingabezeile EZ kann der Nutzer ein Fenster zur Festlegung der Parameter zur Vermessung des Prüfelements aufrufen, die bei Erfüllung des entsprechenden Prüfkriteriums festgelegt werden. Betätigt der Nutzer eine solche Festlegebox FB, beispielsweise durch Betätigung einer entsprechenden Eingabeeinrichtung, so kann sich ein neues Fenster mit den festzulegenden Parametern öffnen. Die Parameter können hierbei prüfelementspezifische Parameter sein. Auch ist es vorstellbar, dass die Parameter bei einem ersten Aufruf einen vorgegebenen Standardwert aufweisen.

Weiter dargestellt ist eine Löschbox LB in einer Eingabezeile EZ, wobei der Nutzer bei Betätigung dieser Löschbox LB das durch die in dieser Zeile eingegebenen Parameter festgelegte Prüfkriterium löschen kann.

Die in Fig. 4 dargestellte Nutzoberfläche kann durch ein sogenanntes Strategie-Editor-Modul erzeugt und dargestellt werden, wobei dieses Modul beispielsweise durch eine Datenverarbeitungseinrichtung 2 (siehe Fig. 7) ausgeführt wird.

Fig. 5 zeigt eine exemplarische Darstellung eines Messobjekts 1. Dieses besteht aus einem ersten Zylinder Cyl1 und einem zweiten Zylinder Cyl2, die verschiedene Durchmesser und verschiedene Längen aufweisen. Diese Zylinder Cyl1, Cyl2 bilden Prüfelemente des Messobjekts 1.

Fig. 6 zeigt eine exemplarische Darstellung einer Nutzeroberfläche eines Strategie-Zuweisungsmoduls. Mit diesem Modul, dessen Funktionalität ebenfalls mittels einer Datenverarbeitungseinrichtung 2 (siehe Fig. 7) bereitgestellt werden kann, können beispielsweise die Prüfelemente Cyl1, Cyl2 bestimmt werden, beispielsweise modellbasiert. Dies wurde vorhergehend bereits erläutert. Hierzu kann z.B. das Strategie-Zuweisungs-Modul ein CAD-Modell des Messobjekts 1 analysieren und die entsprechenden Prüfelemente Cyl1, Cyl2 identifizieren.

In Fig. 6 ist dargestellt, dass in einer Spalte Sp die verschiedenen identifizierten Prüfelemente eines Messobjekts 1 (siehe Fig. 5) dargestellt sind. In dem in Fig. 6 dargestellten Ausführungsbeispiel sind exemplarisch der erste Zylinder Cyl1 und der zweite Zylinder Cyl2 dargestellt.

Durch das Strategie-Zuweisungs-Modul kann dann geprüft werden, ob für jedes der Prüfelemente Cyl1, Cyl2 eine anwendbare Messregel in einer Messregel-Menge von vorab festgelegten Messregeln existiert.

In einer weiteren Spalte, die auch als Regelspalte RSp bezeichnet werden kann, sind in Zeilenform die anwendbaren Messregeln der Messregel-Menge von vorab festgelegten Messregeln dargestellt, die auf das erste Prüfelement, nämlich den ersten Zylinder Cyl1, und die auf den weiteren Zylinder Cyl2 anwendbar sind. So ist in einer ersten Zeile Z als erstes Prüfelement der erste Zylinder Cyl1 und das Prüfkriterium dargestellt, welches der als anwendbar identifizierten Messregel zugeordnet ist. In einer weiteren Zeile Z ist das als weiteres Prüfelement der zweite Zylinder Cyl2 und das Prüfkriterium dargestellt, welches der als anwendbar identifizierten Messregel zugeordnet ist.

Ersichtlich ist, dass dem ersten Zylinder Cyl1 diejenige Messregel zugeordnet ist, die sich ergibt, wenn das Prüfelement eine Zylinderform Cyl aufweist und das Verhältnis von Länge L zu Durchmesser D der Zylinderform Cyl größer gleich 0,0 und kleiner als 1,0 ist. Die entsprechende Messregel wurde z.B. durch die in Fig. 4 dargestellte Nutzeroberfläche insbesondere durch Betätigen der Festlegebox FB und Eingabe der entsprechenden Parameter festgelegt.

Entsprechend ist dem zweiten Zylinder Cyl2 die Messregel zugeordnet, die anwendbar ist, wenn das Prüfelement eine Zylinderform Cyl aufweist und das Verhältnis von Länge L zu Durchmesser D zwischen 1,0 und 3,0 liegt.

Dargestellt sind wiederum Aktivierungsboxen AB, durch deren Aktivierung der Nutzer festlegt, dass die als anwendbar klassifizierte Messregel der Messstrategie hinzugefügt wird.

Weiter dargestellt ist eine Überschreibefunktion, bei deren Aktivierung, z.B. durch einen Nutzer, die in einem Auswahlmenü AM für verschiedene existierende Messstrategien ausgewählte Messstrategie bei Betätigung einer Zuordnungsschaltfläche ZS überschrieben wird. Weiter dargestellt ist eine Erzeugefunktion, bei deren Aktivierung, z.B. durch einen Nutzer, der in einem Eingabefeld EF eingegebene Dateiname bei Betätigung der Zuweiseschaltfläche ZS für die Speicherung der neu erzeugten Messstrategie verwendet wird.

Fig. 7 zeigt ein schematisches Blockschaltbild einer Vorrichtung zur Bestimmung einer Messstrategie zur Vermessung eines Messobjekts 1 (siehe Fig. 5). Die Vorrichtung 3 umfasst eine Datenverarbeitungseinrichtung 2 sowie eine Eingabeeinrichtung 4. Ebenfalls umfasst die Vorrichtung 2 eine Anzeigeeinrichtung 5, insbesondere zur Darstellung der in Fig. 4 und Fig. 6 dargestellten Oberflächen.

Mittels der Eingabeeinrichtung 4 kann ein Nutzer Prüfkriterien bzw. für die Auswertung von Prüfkriterien notwendigen Parameter sowie Messregeln bzw. Parameter einer Messregel eingeben. Auch kann der Nutzer mittels der Eingabeeinrichtung 4 bereits erstellte Messregeln sowie Prüfkriterien verwalten, z.B. ändern, oder neue Messregeln sowie Prüfkriterien hinzufügen oder vorhandene Messregeln sowie Prüfkriterien löschen. Dargestellt ist, dass die Vorrichtung 1 eine Speichereinrichtung 6 umfasst, in der die Messregel-Menge von vorab festgelegten Messregeln sowie die ihnen zugeordneten Prüfkriterien gespeichert werden, um diese dann zur Prüfung auf Anwendbarkeit abrufen zu können.

### Bezugszeichenliste

- 1: Messobjekt
- 2: Datenverarbeitungseinrichtung
- 3: Vorrichtung
- 4: Eingabeeinrichtung
- 5: Anzeigeeinrichtung
- 6: Speichereinrichtung
- 7: Regelgenerator
- S0: Festlegeschritt
- S0a: Prüfkriterium-Festlegeschritts
- S0b: Messregel-Festlegeschritts
- S0b_1: erster Teilschritt des Messregel-Festlegeschritts
- S0b_2: weiterer Teilschritt des Messregel-Festlegeschritts
- S1: Bestimmungsschritt
- S2: Prüfschritt
- S3: Hinzufüge-/Änderungsschritt
- S4: Messschritt
- Cyl: Zylinder, Zylinderform
- PS1, PS2, PS3: Prüfschritt
- PS11: Prüfschritt
- PS12, PS22, PS32: Prüfschritt
- L: Länge
- D: Durchmesser
- Sp: Spalte
- AM, AM1: Auswahlmenü
- AB: Aktivierungsbox
- FB: Festlegebox
- LB: Löschbox
- AM2: Auswahlmenü
- ZS: Zuweiseschaltfläche
- EF: Eingabefeld
- RSp: Regelspalte
- Cyl1: erster Zylinder
- Cyl2: weiterer Zylinder
- EZ: Eingabezeile
- Z: Zeile

## Patentansprüche

1. Verfahren zur Bestimmung einer Messstrategie zur Vermessung eines Messobjekts (1), wobei mindestens ein Prüfelement des Messobjekts (1) bestimmt wird, wobei für das Prüfelement automatisiert geprüft wird, ob eine anwendbare Messregel in einer Messregel-Menge von vorab festgelegten Messregeln existiert, wobei einer neuen Messstrategie eine anwendbare Messregel hinzugefügt oder die prüfelementspezifische Messregel einer existierenden Messstrategie in Abhängigkeit einer anwendbaren Messregel geändert wird,
**dadurch gekennzeichnet, dass**
die Messregeln der Messregel-Menge bestimmt werden, indem für ein Prüfelement eine Messregel sowie mindestens ein Prüfkriterium zu deren Anwendbarkeit durch einen Nutzer oder (teil-)automatisiert festgelegt werden, wobei die Messregel mindestens einen Parameter zur Vermessung des Prüfelements festlegt.

2. Verfahren nach Anspruch 1, **dadurch gekennzeichnet, dass** ein Prüfkriterium derart festgelegt wird, dass bei einer Prüfung des Prüfkriteriums mindestens eine geometrische Eigenschaft des Prüfelements oder eine davon abhängige Größe und/oder eine Umgebungsbedingung und/oder eine vorbestimmte Toleranz und/oder ein Messgerätetyp und/oder ein Sensortyp und/oder ein Bauzustand des Messobjekts (1) und/oder eine Messgüte einer vorangegangenen Vermessung des Messobjekts (1) ausgewertet wird.

3. Verfahren nach Anspruch 2, **dadurch gekennzeichnet, dass** zur Prüfung von anwendbaren Messregeln mindestens eine geometrische Eigenschaft des Prüfelements oder eine davon abhängige Größe und/oder eine Umgebungsbedingung und/oder eine vorbestimmte Toleranz und/oder ein Messgerätetyp und/oder ein Sensortyp und/oder ein Bauzustand des Messobjekts (1) und/oder eine Messgüte einer vorangegangenen Vermessung bestimmt wird.

4. Verfahren nach einem der vorangegangenen Ansprüche, **dadurch gekennzeichnet, dass** verschiedenen Prüfelementen jeweils prüfelementspezifische Eigenschaften zugeordnet sind, wobei für ein Prüfelement ein Prüfkriterium derart festgelegt wird, dass bei einer Prüfung des Prüfkriteriums ausschließlich mindestens eine prüfelementspezifische Eigenschaft des Prüfelements oder eine davon abhängige Größe ausgewertet wird.

5. Verfahren nach einem der vorangegangenen Ansprüche, **dadurch gekennzeichnet, dass** zur Prüfung der Anwendbarkeit einer Messregel für ein Prüfelement mindestens zwei Prüfkriterien festgelegt werden, die in mindestens zwei aufeinanderfolgenden Prüfschritten zu prüfen sind.

6. Verfahren nach Anspruch 5, **dadurch gekennzeichnet, dass** das in einem nachfolgenden Prüfschritt zu prüfende Prüfkriterium abhängig von mindestens einem bereits geprüften Prüfkriterium und/oder abhängig von einem Ergebnis der Prüfung mindestens eines bereits geprüften Prüfkriteriums festgelegt wird.

7. Verfahren nach einem der vorangegangenen Ansprüche, **dadurch gekennzeichnet, dass** ein Prüfelement eine Zylinderform, eine Kreisform, eine Kegelform, eine Kugelform, eine Torusform, eine zweidimensionale Gerade, ein Langloch, eine Ebene, eine Symmetrieebene oder eine Rechteckform ist.

8. Verfahren nach einem der vorangegangenen Ansprüche, **dadurch gekennzeichnet, dass** eine Eigenschaft des Prüfelements eine Durchmessergröße, eine weitere Durchmessergröße, eine Längengröße, eine Breitengröße, ein Verhältnis von Länge zu Durchmesser, ein Verhältnis von Länge zu Breite, eine Distanzgröße, eine Winkelgröße, eine Innen- oder Außenkennung, die Zugehörigkeit zu einer Prüfmerkmalsgruppe oder die Zugehörigkeit zu einem Prüfmerkmalstyp ist.

9. Verfahren nach einem der vorangegangenen Ansprüche, **dadurch gekennzeichnet, dass** die Prüfung, ob eine anwendbare Messregel in der Messregel-Menge existiert, abhängig von mindestens zwei verschiedenen Eigenschaften des Prüfelements durchgeführt wird, wobei die verschiedenen Eigenschaften sequenziell geprüft werden.

10. Verfahren nach Anspruch 9, **dadurch gekennzeichnet, dass** die in einem nachfolgenden Prüfschritt zu prüfende Eigenschaft abhängig von mindestens einer bereits geprüften Eigenschaft und/oder abhängig von einem Ergebnis der Prüfung mindestens einer bereits geprüften Eigenschaft bestimmt wird/werden.

11. Verfahren nach einem der vorangegangenen Ansprüche, **dadurch gekennzeichnet, dass** ein Prüfelement modellbasiert bestimmt wird oder dass das Messobjekt vermessen und das Prüfelement durch Auswertung der Messergebnisse bestimmt wird.

12. Verfahren nach einem der vorangegangenen Ansprüche, **dadurch gekennzeichnet, dass** das Messobjekt (1) gemäß der neuen oder geänderten Messstrategie vermessen und eine Messgüte der Vermessung bestimmt wird, wobei mindestens ein Prüfelement des Messobjekts (1) bestimmt wird, wobei für das Prüfelement automatisiert geprüft wird, ob eine anwendbare Messregel in einer Messregel-Menge von vorab festgelegten Messregeln existiert, wobei die Prüfung in Abhängigkeit der Messgüte erfolgt, wobei die prüfelementspezifische Messregel der neuen Messstrategie geändert oder der geänderten Messstrategie erneut geändert wird, wenn diese Messregel auf das Prüfelement anwendbar ist.

13. Vorrichtung zur Bestimmung einer Messstrategie zur Vermessung eines Messobjekts (1), wobei die Vorrichtung mindestens eine Datenverarbeitungseinrichtung umfasst, wobei mindestens ein Prüfelement des Messobjekts (1) bestimmbar ist, wobei für das Prüfelement mittels der Datenverarbeitungseinrichtung automatisiert geprüft wird, ob eine anwendbare Messregel in einer Messregel-Menge von vorab festgelegten Messregeln existiert, wobei einer neuen Messstrategie eine anwendbare Messregel hinzugefügt oder die prüfelementspezifische Messregel einer existierenden Messstrategie in Abhängigkeit einer anwendbaren Messregel geändert wird,
**dadurch gekennzeichnet, dass**
die Messregeln der Messregel-Menge bestimmt werden, indem für ein Prüfelement eine Messregel sowie mindestens ein Prüfkriterium zu deren Anwendbarkeit durch einen Nutzer oder (teil-)automatisiert festgelegt werden, wobei die Messregel mindestens einen Parameter zur Vermessung des Prüfelements festlegt.

14. Programm, welches, wenn es auf oder durch einen Computer ausgeführt wird, den Computer veranlasst, einen, mehrere oder alle Schritte eines Verfahrens zur Bestimmung einer Messstrategie zur Vermessung eines Messobjekts gemäß einem der Ansprüche 1 bis 12 durchzuführen.
